# EUROPÄISCHE PATENTSCHRIFT

(11) **EP 2 886 606 B1**
(45) Veröffentlichungstag und Bekanntmachung des Hinweises auf die Patenterteilung: **15.11.2017**
(21) Anmeldenummer: 13199139.0
(22) Anmeldetag: 20.12.2013
(51) Int. Cl.: C08L 77/06, C08K 3/00, C08L 77/00, C08K 7/02, C08K 3/22, C08K 3/24, C08K 3/30, C08K 3/32

(54) **Kunststoffformmasse und deren Verwendung**
Plastic moulding material and use of same
Masse de moulage en matière synthétique et son utilisation

(43) Veröffentlichungstag der Anmeldung: 24.06.2015
(73) Patentinhaber: EMS-PATENT AG, 7013 Domat / Ems (CH)
(72) Erfinder: Stöppelmann, Georg, 7402 Bonaduz (CH)
(74) Vertreter: Bremi, Tobias Hans

(56) Entgegenhaltungen:
- WO-A1-2013/141157
- WO-A1-2013/183789
- WO-A1-2014/042071
- WO-A1-2014/042284
- JP-A- 2011 132 550
- DATABASE WPI Week 201425 Thomson Scientific, London, GB; AN 2014-F13953 XP002725098, & WO 2014/042071 A1 (MITSUBISHI ENG-PLASTICS CORP) 20. März 2014 (2014-03-20)

## Beschreibung

### TECHNISCHES GEBIET

Die vorliegende Erfindung betrifft thermoplastische Kunststoffformmassen mit mechanischen Eigenschaften. Die Formmassen enthalten neben Glasfasern ein Weisspigment sowie ein LDS-Additiv. Daraus hergestellte Formteile sind nach partieller Bestrahlung gezielt metallisierbar. Verwendung finden die erfindungsgemäßen Formmassen insbesondere für die Herstellung von spritzgegossenen Schaltungsträgern.

### STAND DER TECHNIK

Moulded Intercontect Devices (MID) - Schaltungsträger aus thermoplastischen Kunststoffen - haben gegenüber bisherigen Schaltungsträgern den Vorteil der verbesserten Gestaltungsfreiheit, der guten Umweltverträglichkeit und des Rationalisierungspotentials bezüglich des Herstellverfahrens des Endproduktes. Die Integration von elektrischen und mechanischen Funktionen in einem Spritzgussteil kann zu einer Miniaturisierung der Baugruppe führen. Ausserdem können ganz neue Funktionen realisiert und nahezu beliebige Formen gestaltet werden. 2-Komponenten-Spritzgiessen, Heissprägen und Laser-Subtraktiv-Strukturieren sind bereits seit einigen Jahren in der Serienfertigung eingesetzte MID-Fertigungstechnologien.

Aus der EP-A-1 274 288 ebenfalls bekannt ist die additive Laser-Strukturierungstechnik (Laser Direct Structuring, LDS), bei welcher das im Standard-Spritzgiessverfahren hergestellte Formteil durch einen Laser strukturiert wird. Hierdurch werden auf der Kunststoffoberfläche partiell diejenigen Bereiche, die später die Leitungsbahnen tragen sollen, mit Metallatomen bekeimt, auf denen nachfolgend in chemisch reduktiven Metallisierungsbädern eine Metallschicht wächst. Die Metallkeime entstehen durch Aufbrechen von feinstverteilt im Trägermaterial enthaltenen Metallverbindungen. Besonders gut geeignete Metallverbindungen für die Laserdirektstrukturierung sind kupferhaltige Metalloxide mit Spinellstruktur. Nicht bestrahlte Kunststoffbereiche bleiben im Metallisierungsbad unverändert erhalten. Im einzigen Beispiel der EP-A-1 274 288 wird die Formmasse aus 70 Gew.-% Polybutylenterephthalat, 30 Gew.-% Kieselsäure und 5 Gew.-% eines Kupfer-Chrom-Spinells zu einem Gehäuse für ein Mobiltelefone verarbeitet, welches durch einen Nd-YAG-Laser bestrahlt und nachfolgend im reduktiven Verkupferungsbad metallisiert wird.

WO-A-2013/076314 beschreibt mit einem Laser direkt strukturierbare thermoplastische Formmassen, die ein auf Zinn und einem weiteren Metall aus einer bestimmten Gruppe basierendes Metallmischoxid als LDS-Additiv enthalten und zeigt anhand von unverstärkten Formmassen aus Polycarbonat oder Polycarbonat-ABS-Mischungen, dass diese Formmassen einen guten Weissgrad besitzen und dass die Metallisierung mit steigendem Anteil an Anitmonoxid verbessert werden kann.

WO-A-2012/056416 weist bei ebenfalls auf Basis von unverstärkten und nicht flammgeschützten Polycarbonat/ABS-Blends darauf hin, dass der Zusatz von Titandioxid unabhängig vom Typ des verwendeten LDS-Additivs zu Formmassen mit gutem Weissgrad führen kann.

Aus der WO2013183789 ist eine Harzzusammensetzung mit ausgezeichneter mechanischer Festigkeit unter Beibehaltung der LDS Aktivität bekannt. Die Harzzusammensetzung zur Laserdirektstrukturierung umfasst, bezogen auf 100 Gewichtsteile einer Polycarbonatharzkomponente, 10 bis 100 Gewichtsteile eines Glas-Füllstoffs und 1 bis 30 Gewichtsteile eines Additivs zur Laserdirektstrukturierung, wobei die Polycarbonatharzkomponente aus 80 bis 30 Gewichts-% eines Polycarbonatharzes und 20 bis 70 Gewichts-% eines Harzes auf Styrolbasis, oder aus einem Polycarbonat besteht und das Laserdirektstrukturierungsadditiv auf Antimon und Zinn beruht.

Aus der WO2013141157 ist eine thermoplastische Harzzusammensetzung mit hoher Wärmebeständigkeit beim Löten, ausgezeichneten Beschichtungseigenschaften, auch nach der Alterungsbehandlung, und mit einer hohen Reflektivität bekannt. Die thermoplastische Harzzusammensetzung umfasst: 10-80 Gewichtsteile eines Glas-Füllstoffs (B), 1-30 Gewichtsteile eines Laserdirektstrukturierungsadditivs (C) mit 25% oder mehr Reflektivität bei einer Wellenlänge von 450 nm, und 20 -150 Gewichtsteile Titanoxid (D), bezogen auf 100 Gew.-Teile eines kristallinen thermoplastischen Harzes (A) mit einem Schmelzpunkt von 250°C oder höher.

### DARSTELLUNG DER ERFINDUNG

Ausgehend hiervon war es Aufgabe der vorliegenden Erfindung, für die MID -Technik geeignete thermoplastische Kunststoffformassen, insbesondere Polyamidformmassen, und insbesondere solche, die neben Glasfasern auch Weisspigmente und LDS-Additive enthalten, bereitzustellen, mit denen Formkörper mit guten mechanischen Eigenschaften, insbesondere mit hoher Steifigkeit, hoher Reissfestigkeit und guter Schlagzähigkeit herstellbar sind, die eine hohe Farbhelligkeit L* bzw. eine gute Einfärbbarkeit und die nicht die Nachteile des Standes der Technik aufweisen. Darüber hinaus sollen die Formkörper nach Laserbestrahlung gut metallisierbar sein und die Leiterbahnen sollen eine gute Haftung am Polymersubstrat aufweisen.

Die thermischen und mechanischen Eigenschaften sowie die damit verbundenen Einsatzgebiete dieser Schaltungsträger werden in erster Linie durch die zugrundeliegende thermoplastische Formmasse bestimmt. Polyamide sind heutzutage weit verbreitet als Strukturelemente für den Innen- und Außenbereich, was im Wesentlichen auf die hervorragenden mechanischen Eigenschaften zurückzuführen ist.

Eine Verbesserung der mechanischen Eigenschaften, wie Festigkeit und Steifheit, lässt sich insbesondere durch den Zusatz faserförmiger Verstärkungsstoffe, z.B. Glasfasern oder Carbonfasern, erreichen. In vielen Fällen werden neben den Glasfasern auch noch teilchenförmige Füllstoffe verwendet, sei es, um die Formmassen mittels anorganischer Pigmente einzufärben oder spezifische Eigenschaftsmodifizierungen vorzunehmen.

Die laserdirektstrukturierbaren Formmassen enthalten sogenannte Laseradditive, die bei Einwirkung von elektromagnetischen Strahlen Metalle freisetzen. Für diese laserinduzierte Bekeimung kommen häufig Metalloxide, insbesondere Spinelle zum Einsatz. Zur Erhöhung der Mikrorauhigkeit und damit der Haftung der später aufgetragenen Leiterbahn können solche Formmassen zusätzlich noch beträchtliche Mengen an weiteren Füllstoffen enthalten, wie z.B. Talk. Durch den Zusatz von partikulären Füllstoffen oder Weisspigmenten zu den glasfaserverstärkten Formmassen werden die mechanischen Eigenschaften aber in der Regel deutlich verschlechtert, insbesondere wird die Reissfestigkeit, die Reissdehnung sowie die Schlagzähigkeit reduziert. Dies hat zur Konsequenz, dass in Verbindung mit Glasfasern keine oder nur geringe Gehalte an partikulären Füllstoffen, eingesetzt werden können, wenn die Steifigkeit, die Reissfestigkeit sowie die Schlagzähigkeit als kritische Parameter für das Formteil angesehen werden.

Einerseits bewirkt der Zusatz der für MID-Formmassen erforderlichen partikulären Füllstoffe und Weisspigmente zu glasfaserverstärkten Formmassen die Funktionalität der Laserstrukturierbarkeit und der Leiterbahnhaftung bei heller Eigenfarbe, führt aber andererseits zu einer Verschlechterung hinsichtlich der mechanischen Eigenschaften, wie der Reissfestigkeit und der Zähigkeit. In diesem Spannungsfeld ist die vorliegende Erfindung zu sehen.

Konkret betrifft die Erfindung eine Formmasse, insbesondere mit hoher Steifigkeit, Reissfestigkeit und Schlagzähigkeit, sowie heller Eigenfarbe (hohe Farbhelligkeit L*) bzw. guter Einfärbbarkeit nach Anspruch 1, insbesondere bestehend aus:
(A) 20 - 88 Gew.-% einer Mischung bestehend aus
   (A1) 60 - 100 Gew.-% eines thermoplastischen Kunststoffes oder einer Mischung thermoplastischer Kunststoffe bestehend aus
      (A1_1) 40 - 100 Gew.-% aliphatischem Polyamid
      (A1_2) 0 - 60 Gew.% amorphem, teilaromatischem Polyamid
      wobei sich die Summe der Komponenten (A1_1) und (A1_2) auf 100 Gew.-% der Komponente (A1) ergänzt;
   (A2) 0 - 40 Gew.-% einer Mischung aus
      (A2_1) 0 - 40 Gew.-% eines thermoplastischen Kunststoffes verschieden von (A1) oder einer Mischung thermoplastischer Kunststoffe verschieden von (A1);
      (A2_2) 0 - 40 Gew.-% Schlagzähmodifier verschieden von (A1) und (A2_1);
      wobei sich die Summe der Komponenten (A1), (A2_1) und (A2_2) auf 100 Gew.-% der Komponente (A) ergänzt;
(B) 10 - 70 Gew.-% faserförmigen Zuschlagstoffen;
(C) 0.1 - 10 Gew.-% eines LDS-Additivs oder einer Mischung von LDS-Additiven, wobei mindestens ein LDS-Additiv ausgewählt ist aus der folgenden Gruppe: Metalloxid auf Basis von Kupfer, Neodym, Molybdän, Wismut und/oder Zinn, mit der Massgabe, dass Spinelle ausgeschlossen sind; Metallphosphat, bevorzugt basisches Metallphosphat; Metallhydroxidphosphat; bevorzugt auf Basis von anorganischen Verbindungen des Kupfers und/oder Zinns, wie vorzugsweise Zinnoxid, bevorzugt Antimon dotiertes Zinnoxid, insbesondere ein mit Antimon-dotiertem Zinnoxid beschichteten Glimmer;
(D) 0.1 - 20 Gew.-% Weisspigment;
(E) 0 - 20 Gew.-% partikulärer Füllstoff, verschieden von C und/oder D;
(F) 0 - 2 Gew.-% weitere andere Additive;
wobei die Summe aus (A) - (F) 100 Gew.-% ausmacht. Dabei besteht die **Komponente (A)** aus:
(A1) 60 - 100 Gew.-% einer Mischung bestehend aus
   (A1_1) 40 - 100, bevorzugt 50 - 95 Gew.-% aliphatisches Polyamid
   (A1_2) 0 - 60, bevorzugt 5 - 50 Gew.-% amorphes, teilaromatisches Polyamid wobei sich die Summe der Komponenten (A1_1) und (A1_2) auf 100 Gew.-% der Komponente (A1) ergänzt;
(A2) 0 - 40 Gew.-% einer Mischung bestehend aus
   (A2_1) 0 - 40 Gew.-% thermoplastischer Kunststoff verschieden von (A1)
   (A2_2) 0 - 40 Gew.-% Schlagzähmodifier verschieden von (A1) und (A2_1) wobei sich die Summe der Komponenten (A1), (A2_1) und (A2_2) auf 100 Gew.-% der Komponente (A) ergänzt.

Die **Komponente (A1)** und/oder die **Komponente (A2_1)** kann dabei ausgewählt sein aus der Gruppe bestehend aus: Polyamid, Polycarbonat, Polystyrol, Polymethylmethacrylat, Acrylnitril-Butadien-Styrol-Copolymerisat, Acrylnitril-Styrol-Copolymer, Polyolefin, Polyoxymethylen, Polyester, insbesondere Polyethylenterephthalat, Polybutylenterephthalat, Polysulfon, insbesondere des Typs PSU, PESU, PPSU, Polyphenylenether, Polyphenylensulfid, Polyphenylenoxid, flüssigkristalline Polymere, Polyetherketon, Polyetheretherketon, Polyimid, Polyamidimid, Polyesterimid, Polyetheramid, Polyesteramid, Polyetheresteramid, Polyurethan, insbesondere des Typs TPU, PUR, Polysiloxan, Polyacrylat, Polymethacrylat sowie Mischungen oder Copolymere auf Basis solcher Systeme. Solche Systeme (A1) können dabei weiterhin bevorzugt in Kombination mit den unten angegebenen Schlagzähmodifikatoren, einer bevorzugten Ausführungsform von Komponente A2, eingesetzt werden. Bevorzugtermassen besteht dabei die Komponente (A1) ganz aus Polyamid oder einer Mischung von verschiedenen Polyamiden.

Bevorzugtermassen liegt dabei der Anteil an Komponente (A) im Bereich von 25-84 Gew.-%, vorzugsweise im Bereich von 30-80 Gew.-%. wobei vorzugsweise auch der Gesamtanteil von (A) in Form von Polyamid (A1) im Bereich von 25-84 Gew.-% liegt, insbesondere vorzugsweise im Bereich von 30-80 Gew.-%.

Der Anteil der Komponente (A2_1) liegt vorzugsweise im Bereich von 5-40 Gew.-%, vorzugsweise im Bereich von 5-30 Gew.-% oder im Bereich von 5-20 Gew.-%, jeweils bezogen auf die Summe der Komponenten (A1), (A2_1) und (A2_2).

Der Anteil der weiteren Matrix-Komponente (A2) als ganzes innerhalb der Komponente (A) und bezogen auf die Gesamtmenge der Komponente (A) liegt bevorzugtermassen im Bereich von 0-20 Gew.-%, vorzugsweise im Bereich von 0-10 Gew.-% oder im Bereich von 5-15 Gew.-%. Bevorzugtermassen gibt es aber keine weitere Matrix-Komponente (A2), d.h. bevorzugtermassen liegt in der Formmasse ausschliesslich Komponente (A1) vor.

In einer weiteren Ausführungsform enthält die erfindungsgemässe Formmasse als **Komponente (A2_2)** bis zu 40 Gew.-% eines oder mehrerer Schlagzähmodifikatoren (SZM). Bevorzugt wird eine SZM-Konzentration im Bereich zwischen 5 und 40 Gew.%, insbesondere von 5-30 Gew.-%. Werden die Komponenten A2_1 und A2_2 zusammen verwendet, beträgt das Verhältnis A2_1 : A2_2 wenigstens 1:1, bevorzugt 1.2:1, besonders bevorzugt 1.5:1 und liegt damit im Bereich von 1:1 bis 1:10, bevorzugt im Bereich von 1.2:1 bis 1:10, besonders bevorzugt im Bereich von 1.5:1 bis 1:8.

Generell kann die Komponente (A2_2) ausgewählt sein aus der Gruppe bestehend aus: Olefinpolymere, niedrig-, mittel- und hochdichte Polyethylene, Polypropylen, Polybutadien, Poly-4-methylpenten, Ethylen-Propylen-Block- oder statistische Copolymere, Ethylen-Methylhexadien-Copolymere, Propylen-Methylhexadien-Copolymere, Ethylen-Propylen-Buten-Copolymere, Ethylen-Propylen-Hexen-Copolymere, Ethylen-Propylen-Methylhexadien-Copolymere, Poly(ethylen-vinylacetat) (EVA), Poly(ethylen-ethylacrylat) (EEA), Ethylen-Octen-Copolymer, Ethylen-Buten-Copolymer, Ethylen-Hexen-Copolymer, Ethylen-Propylen-Dien-Terpolymere sowie Kombinationen der genannten Polymere, bevorzugt funktionalisiert mit Säureanhydridgruppen.

Der Anteil der Komponente (A2_2) kann im Bereich von 5-40 Gew.-% liegen, vorzugsweise im Bereich von 5-30 Gew.-% oder im Bereich von 5-20 Gew.-%, jeweils bezogen auf die Summe der Komponenten (A1), (A2_1) und (A2_2).

Der SZM kann ein Naturkautschuk, Polybutadien, Polyisopren, Polyisobutylen, ein Mischpolymerisat des Butadiens und/oder Isoprens mit Styrol oder Styrolderivaten und anderen Comonomeren, ein hydriertes Mischpolymerisat und oder ein Mischpolymerisat, das durch Pfropfen oder Copolymerisation mit Säureanhydriden, (Meth)acrylsäure und deren Ester entstanden ist, sein. Der Schlagzähmodifier (A2_2) kann auch ein Pfropfkautschuk mit einem vernetzten elastomeren Kern, der aus Butadien, Isopren oder Alkylacrylaten besteht und eine Pfropfhülle aus Polystyrol hat, ein unpolares oder polares Olefinhomo- und copolymeres wie Ethylen-Propylen-, Ethylen-Propylen-Dien- und Ethylen-Octen- oder Ethylen-Vinylacteat-Kautschuk oder ein unpolares oder polares Olefinhomo- und copolymeres, das durch Pfropfen oder Copolymerisation mit Säureanhydriden, (Meth)acrylsäure und deren Ester entstanden ist, sein. Der Schlagzähmodifier (A2_2) kann auch ein carbonsäure- funktionalisiertes Copolymeres wie Poly(ethen-co-(meth)acrylsäure) oder Poly(ethen-co-1-olefin-co-(meth)acrylsäure) sein, wobei das 1-Olefin ein Alken oder ein ungesättigter (Meth)acrylsäureester mit mehr als 4 Atomen sein kann, einschliesslich solchen Copolymeren, in denen die Säuregruppen teilweise mit Metallionen neutralisiert sind.

Bevorzugte Schlagzähmodifikatoren der Komponente (A2_2) auf Basis von Styrolmonomeren (Styrol und Styrolderivate) und anderen vinylaromatischen Monomeren sind Blockcopolymere aufgebaut aus alkenylaromatischen Verbindungen und einem konjungierten Dien, sowie hydrierte Blockcopolymere aus einer alkenylaromatischen Verbindung und konjungierten Dienen oder Kombinationen dieser SZM-Typen. Das Blockcopolymer enthält mindestens einen Block abgeleitet von einer alkenylaromatischen Verbindung (A) und wenigstens einem Block abgeleitet von einem konjungierten Dien (B).

Bei den hydrierten Blockcopolymeren wurde der Anteil an aliphatisch ungesättigten Kohlenstoff-Kohlenstoff-Doppelbindungen durch Hydrierung reduziert. Als Blockcopolymere sind Zwei-, Drei-, Vier- und Polyblockcopolymere mit linearer Struktur geeignet. Jedoch sind verzweigte und sternförmige Strukturen ebenfalls einsetzbar. Verzweigte Blockcopolymere erhält man in bekannter Weise, z.B. durch Pfropfreaktionen von polymeren "Seitenästen" auf eine Polymer-Hauptkette. Als alkenylaromatische Monomere können neben oder in Mischung mit Styrol, auch vinylaromatische Monomere verwendet werden, die am aromatischen Ring und/oder an der C=C-Doppelbindung mit C1-20-Kohlenwasserstoffresten oder Halogenatomen substituiert sind.

Beispiele für alkenylaromatische Monomere sind Styrol, p-Methylstyrol, α-Methylstyrol, Ethylstyrol, tert.-Butylstyrol, Vinyltoluol, 1,2-Diphenylethylen, 1,1-Diphenylethylen, Vinylxylole, Vinyltoluole, Vinylnaphthaline, Divinylbenzole, Bromstyrole, Chlorstyrole, sowie Kombinationen davon. Bevorzugt werden Styrol, p-Methylstyrol, alpha-Methylstyrol und Vinylnaphthalin.

Als Dienmonomere kommen z.B. 1,3-Butadien, 2-Methyl-1,3-butadien, 2,3-Dimethyl-1,3-butadien, 1,3-Pentadien, 1,3-Hexadien, Isopren, Chloropren und Piperylen in Betracht. 1,3-Butadien und Isopren sind bevorzugt, insbesondere 1,3-Butadien (nachfolgend kurz als Butadien bezeichnet).

Bevorzugt verwendet man als alkenylaromatisches Monomer Styrol und als Dienmonomer Butadien, d.h. bevorzugt ist das Styrol-Butadien-Blockcopolymer. In der Regel werden die Blockcopolymere durch anionische Polymerisation in an sich bekannter Weise hergestellt.

Weiterhin kann man zusätzlich zu den Styrol- und Dienmonomeren weitere Comonomere mitverwenden. Der Anteil der Comonomeren beträgt bevorzugt 0 bis 50, besonders bevorzugt 0 bis 30 und insbesondere 0 bis 15 Gew.-%, bezogen auf die Gesamtmenge der eingesetzten Monomeren. Geeignete Comonomere sind z.B. Acrylate, insbesondere C1-12-Alkylacrylate wie n-Butylacrylat oder 2-Ethylhexylacrylat, und die entsprechenden Methacrylate, insbesondere C1-12-Alkylmethacrylate wie Methylmethacrylat (MMA). Weitere mögliche Comonomere sind (Meth)acrylnitril, Glycidyl(meth)acrylat, Vinylmethylether, Diallyl- und Divinylether bifunktioneller Alkohole, Divinylbenzol und Vinylacetat.

Zusätzlich zum konjugierten Dien enthalten die hydrierten Blockcopolymere der Komponente (A2) gegebenenfalls noch Anteile an niederen Kohlenwasserstoffen wie z.B. Ethylen, Propylen, 1-Buten, Dicyclopentadien oder nicht-konjugierte Diene. In den hydrierten Blockcopolymeren ist der Anteil der nicht reduzierten aliphatischen ungesättigten Bindungen, die aus dem Block B resultieren, kleiner 50%, bevorzugt kleiner 25%, insbesondere kleiner 10%. Die aromatischen Anteile aus Block A werden maximal zu 25% reduziert. Die hydrierten Blockcopolymere Styrol-(ethylen-butylen)-Zweiblock und Styrol-(ethylen-butylen)-styrol-Dreiblock-Copolymere werden durch Hydrierung von Styrol-butadien- und Styrol-butadien-styrol-Copolymeren erhalten. Die Blockcopolymere bestehen bevorzugt zu 20 bis 90 Gew.-% aus Block A, insbesondere zu 50 bis 85 Gew.-% aus Block A. Das Dien kann in 1,2- oder in 1,4-Orientierungen in den Block B eingebaut werden.

Beispiele für nicht-hydrierte Blockcopolymere sind Polystyrol-polybutadien, Polystyrol-poly(ethyen-propylen), Polystyrol-polyisopren, Poly(α-methyl-styrol)-polybutadien, Polystyrene-polybutadien-polystyrol (SBS), Polystyrol-Poly(ethylene-propylen)-polystyrol, Polystyrol-polyisopren-polystyrol und Poly(α-methylstyrol-polybutadiene-poly(α-methylstyrol), als auch Kombinationen davon.

Geeignete nicht-hydrierte Blockcopolymere, die kommerziell erhältlich sind, sind verschiedene Produkte mit dem Markennamen SOLPRENE® (Phillips), KRATON® (Shell), VECTOR® (Dexco) und SEPTON® (Kuraray).

Gemäss einer weiteren bevorzugten Ausführungsform sind die erfindungsgemässen Formmassen dadurch gekennzeichnet, dass die Komponente (A2_2) ein Polyolefinhomopolymeres oder ein Ethylen-α-Olefin-Copolymeres, insbesondere bevorzugt ein EP- und/oder EPDM-Elastomer (Ethylen-Propylen-Kautschuk respektive Ethylen-Propylen-Dien-Kautschuk), enthält. So kann es sich beispielsweise um ein Elastomer handeln, welches basiert auf einem Ethylen-C3-12- a -Olefin-Copolymer mit 20 bis 96, bevorzugt 25 bis 85 Gew.-% Ethylen, wobei es sich insbesondere bevorzugt bei dem C3-12-α-Olefin um ein Olefin ausgewählt aus der Gruppe Propen, 1-Buten, 1-Penten, 1-Hexen, 1-Octen, 1-Decen und/oder 1-Dodecen handelt, und es sich insbesondere bevorzugt bei der Komponente C um Ethylen-Propylen-Kautschuk und/oder LLDPE und/oder VLDPE handelt.

Alternativ oder zusätzlich (beispielsweise in Mischung) kann (A2) ein Terpolymeres auf Basis von Ethylen-C3-12-α-Olefin mit einem unkonjugierten Dien enthalten, wobei dieses bevorzugtermassen 25 bis 85 Gew.-% Ethylen und bis maximal im Bereich von 10 Gew.-% eines unkonjugierten Diens enthält, wobei es sich insbesondere bevorzugt bei dem C3-12-α-Olefin um ein Olefin ausgewählt aus der Gruppe Propen, 1-Buten, 1-Penten, 1-Hexen, 1-Octen, 1-Decen und/oder 1-Dodecen handelt, und/oder wobei das unkonjugierte Dien bevorzugt ausgewählt ist aus der Gruppe Bicyclo(2.2.1) heptadien, Hexadien-1.4, Dicyclopentadien und/oder insbesondere 5-Ethylidennorbornen.

In Frage als Bestandteil für die Komponente (A2_2) kommen zudem auch Ethylen-Acrylat-Copolymere. Weitere mögliche Formen als Bestandteile für die Komponente (A2_2) sind die Ethylen-Butylen-Copolymere beziehungsweise Mischungen (Blends), welche derartige Systeme enthalten.

Bevorzugtermassen verfügt die Komponente (A2_2) über Bestandteile mit Säureanhydridgruppen, die durch thermische oder radikalische Reaktion des Hauptkettenpolymers mit einem ungesättigten Dicarbonsäureanhydrid, einer ungesättigten Dicarbonsäure oder einem ungesättigten Dicarbonsäuremonoalkylester in einer Konzentration eingebracht werden, die für eine gute Anbindung an das Polyamid ausreicht, wobei dafür Reagenzien ausgewählt aus der folgenden Gruppe bevorzugtermassen eingesetzt werden: Maleinsäure, Maleinsäureanhydrid, Maleinsäuremonobutylester, Fumarsäure, Aconitsäure und/oder Itaconsäureanhydrid.

Vorzugsweise werden 0.1 bis 4.0 Gew.-% eines ungesättigten Anhydrids an die Schlagzähkomponente als Bestandteil von (A2_2) aufgepfropft oder das ungesättigte Dicarbonsäureanhydrid oder dessen Vorstufe wird zusammen mit einem weiteren ungesättigten Monomeren aufgepfropft. Generell ist der Pfropfgrad bevorzugtermassen in einem Bereich von 0.1-1.0%, insbesondere bevorzugt in einem Bereich von 0.3-0.7%. Auch möglich als Bestandteil der Komponente (A2_2) ist eine Mischung aus einem Ethylen-Propylen-Copolymer und einem Ethylen-Butylen-Copolymer, dies mit einem Maleinsäureanhydrid-Pfropfgrad (MAH-Propfgrad) im Bereich von 0.3-0.7%. Die oben angegebenen möglichen Systeme für die Komponente können auch in Mischungen verwendet werden.

Weiterhin kann die Komponente (A2_2) über Bestandteile verfügen, welche über funktionelle Gruppen, wie z.B. Carbonsäure-, Ester-, Epoxy-, Oxazolin-, Carbodiimid-, Isocyanat-, Silanol- und Carboxylat-Gruppen verfügen, oder Kombinationen von zwei oder mehrerer der genannten funktionellen Gruppen enthalten. Monomere, die diese funktionellen Gruppen tragen, können durch Co-Polymerisation oder Pfropfung an das elastomere Polyolefin gebunden werden. Ausserdem können die SZM auf Basis der Olefinpolymere auch durch Pfropfung mit einer ungesättigten Silanverbindung, z. B. Vinyltrimethoxysilan, Vinyltriethoxysilan, Vinyltriacetosilan, Methacryloxypropyltrimethoxysilan oder Propenyltrimethoxysilan modifiziert sein.

Die elastomeren Polyolefine sind statistische, alternierende oder segmentierte Copolymere mit linearer, verzweigter oder Core-Shell-Struktur und enthalten funktionelle Gruppen, die mit den Endgruppen der Polyamide reagieren können, so dass eine ausreichende Verträglichkeit zwischen Polyamid und SZM resultiert.

Die als Komponente (A2_2) eingesetzten SZM schliessen damit Homopolymere oder Copolymere von Olefinen, wie z.B. Ethylen, Propylen, Buten-1, oder Copolymere von Olefinen und copolymerisierbaren Monomeren, wie Vinylacetat, (Meth)acrylsäureester und Methylhexadien, ein.

Besonders bevorzugt werden folgende Olefinpolymere: Niedrig-, mittel- und hochdichte Polyethylene, Polypropylen, Polybutadien, Poly-4-methylpenten, Ethylen-Propylen-Block- oder statistische Copolymere, Ethylen-Methylhexadien-Copolymere, Propylen-Methylhexadien-Copolymere, Ethylen-Propylen-Buten-Copolymere, Ethylen-Propylen-Hexen-Copolymere, Ethylen-Propylen-Methylhexadien-Copolymere, Poly(ethylenvinylacetat) (EVA), Poly(ethylen-ethylacrylat) (EEA), Ethylen-Octen-Copolymer, Ethylen-Buten-Copolymer, Ethylen-Hexen-Copolymer, Ethylen-Propylen-Dien-Terpolymere sowie Kombinationen der genannten Polymere. Insbesondere ist bevorzugt, wenn diese Olefinpolymere mit Säureanhydridgruppen funktionalisiert sind.

Beispiele für kommerziell erhältliche Schlagzähmodifier, welche im Rahmen der Bestandteile der Komponente (A2_2) eingesetzt werden können, sind: TAFMER MC201, TAFMER MH5010, TAFMER MH7010, TAFMER MH7020 von Mitsui Chemicals; EXXELOR VA1801, EXXELOR VA1803, EXXELOR VA1810, EXXELOR MDEX 94-11, Exxon Mobile Chemical; FUSABOND MN493D, FUSABOND A EB560D; ELVALOY, DuPont.

Bevorzugt wird auch ein Ionomer im Rahmen von Komponente (A2), in welchem die polymergebundenen Carboxylgruppen ganz oder teilweise durch Metallionen miteinander verbunden sind.

Besonders bevorzugt sind durch Pfropfen mit Maleinsäureanhydrid funktionalisierte Mischpolymerisate des Butadiens mit Styrol, unpolare oder polare Olefinhomo- und Copolymere, die durch Pfropfen mit Maleinsäureanhydrid entstanden sind und carbonsäurefunktionalisierte Copolymere wie Poly(ethen-co-(meth)arylsäure) oder Poly(ethen-co-1-olefin-co-(meth)acrylsäure), in denen die Säuregruppen teilweise mit Metallionen neutralisiert sind.

Die erfindungsgemässe Formmasse besteht bevorzugt aus 20 bis 88 Gew.-% aus einer thermoplastischen **Kunststoffmischung (A)** aus **Polyamid (A1)** und einem **thermoplastischen Kunststoff (A2)** nicht auf Polyamidbasis, wobei die Konzentration von (A2) höchstens 40 Gew.-% bezogen auf die Mischung A ausmacht. Komponente A1 besteht dabei bevorzugt aus 50 - 100 Gew.-% aliphatischen Polyamiden. Insbesondere ist Komponente (A1) eine Mischungen aus teilkristallinen, aliphatischen Polyamiden (Komponente A1_1) und amorphen, teilaromatischen Polyamiden (Komponente A1_2), wobei der Anteil an aliphatischem Polyamid wenigstens 50 Gew.-%, bevorzugt wenigstens 60 Gew.-% und besonders bevorzugt wenigstens 65 Gew.-% beträgt. Die Konzentration von Komponente (A1_2) liegt dabei im Bereich von 5-50 Gew.-%, bevorzugt im Breich von 7-40 Gew.-% und besonders bevorzugt im Bereich von 10-35 Gew.-%.

Die Komponente (A1) kann also aus aliphatischem Polyamid bestehen oder aus einer Polyamidmischung, welche mindestens 60 Gew.-% aliphatisches Polyamid, bevorzugt 60 bis 93 Gew.-% aliphatisches Polyamid enthält, jeweils bezogen auf die Gesamtmenge der Komponente (A1). Die Komponente (A1) kann auch aus einer Mischung von aliphatischem Polyamid (A1_1) und amorphem, teilaromatischem Polyamid (A1_2) bestehen.

Somit umfasst die Erfindung insbesondere auch eine thermoplastische Formmasse bestehend aus:
(A) 25 - 84 Gew.-% einer Mischung (A) aus
   (A1) 60 - 100 Gew.-% einer Mischung aus
      (A1_1) 50 - 95 Gew.-% aliphatisches Polyamid;
      (A1_2) 5 - 50 Gew.-% amorphes, teilaromatisches Polyamid;
      wobei sich die Summe aus (A1_1) und (A1_2) auf 100 Gew.-% der Komponente (A1) ergänzt;
   (A2) 0 - 40 Gew.-% einer Mischung aus
      (A2_1) 0 - 40 Gew.-% thermoplastischer Kunststoff verschieden von (A1);
      (A2_2) 0 - 40 Gew.-% Schlagzähmodifier verschieden von A1 und A2_1;
      wobei sich die Summe aus (A1), (A2_1) und (A2_2) auf 100 Gew.-% der Komponente (A) ergänzt;
(B) 15 - 60 Gew.-% faserförmigen Zuschlagstoffen
(C) 0.1 - 10 Gew.-% eines LDS-Additivs oder eine Mischung von LDS-Additiven, wobei mindestens ein LDS-Additiv ganz oder teilweise
   - ein Metalloxid auf Basis von Kupfer, Neodym, Molybdän, Wismut oder Zinn, wobei Spinelle ausgeschlossen sind,
   - ein Metallphosphat, basisches Metallphosphat oder Metallhydroxidphosphat, bevorzugt auf Basis von anorganischen Verbindungen des Kupfers und/oder Zinns,
   - ein Zinnoxid, bevorzugt Antimon dotiertes Zinnoxid, insbesondere ein mit Antimon-dotiertem Zinnoxid beschichteten Glimmer ist;
(D) 0.5 - 10 Gew.-% Weisspigment, insbesondere Titandioxid, Zinkoxid oder Zinksulfid, insbesondere Zinksulfid;
(E) 0 - 20 Gew.-% partikulärer Füllstoff, verschieden von C und D;
(F) 0 - 2 Gew.-% weitere andere Additive;
wobei die Summe aus (A) - (F) 100 Gew.-% ausmacht.

Die genannten **Polyamide (A1)** können aus folgenden Dicarbonsäuren hergestellt werden: Adipinsäure, Korksäure, Azelainsäure, Sebacinsäure, Undecandisäure, Dodecandisäure, Tridecandisäure, Tetradecandisäure, Pentadecandisäure, Hexadecandisäure, Heptadecandisäure, Oktadecandisäure, C36-Dimerfettsäure, Isophthalsäure, Terephthalsäure, Naphthalindicarbonsäure, cis- und/oder trans-Cyclohexan-1,4-dicarbonsäure und/oder cis- und/oder trans-Cyolohexan-1,3-dicarbonsäure (CHDA) und Gemischen daraus.

Als Diamine kommen folgende Monomere in Frage: 1,4-Butandiamin, 1,5-Pentandiamin, 2-Methyl-1,5-pentandiamin, 2-Butyl-2-ethyl-1,5-pentandiamin, 1,6-Hexandiamin, 2,2,4-Trimethylhexamethylendiamin, 2,4,4-Trimethylhexamethylendiamin, 1,8-Octandiamin, 2-Methyl-1,8-octandiamin, 1,9-Nonandiamin, 1,10-Decandiamin, 1,11-Undecandiamin, 1,12-Dodecandiamin, 1,13-Tridecandiamin, 1,14-Tetradecandiamin, m-Xylylendiamin und p- Xylylendiamin.

Weiterhin können die Polyamide auch auf Lactamen oder Aminocarbonsäuren, insbesondere α,ω-Aminosäuren oder Lactame mit 6 bis 12 Kohlenstoffatome aufgebaut sein, wobei beispielhaft nachfolgende Auswahl genannt sei: m-Aminobenzoesäure, p-Aminobenzoesäure Caprolactam (CL), ω-Aminocapronsäure, ω-Aminoheptansäure, ω-Aminoctansäure, ω-Aminononansäure, ω-Aminodecansäure, ω-Aminoundecansäure (AUA), Laurinlactam (LL) und ω-Aminododecansäure (ADA). Besonderes bevorzugt sind Caprolactam, Aminocapronsäure, Laurinlactam und Aminododecansäure.

Die Polyamide A1_1 oder A1_2 haben vorzugsweise eine Lösungsviskosität ηᵣₑₗ, gemessen in m-Kresol (0,5 Gew.-%, 20°C) im Bereich von 1,4 bis 3.0, bevorzugt im Bereich von 1,5 bis 2.7, insbesondere im Bereich von 1,5 bis 2.4.

Als **aliphatische Polyamide (A1_1)** werden bevorzugt Polyamid 46, Polyamid 6, Polyamid 66, Polyamid 11, Polyamid 12, Polyamid 1212, Polyamid 1010, Polyamid 1012, Polyamid 1112, Polyamid 610, Polyamid 612, Polyamid 69, Polyamid 810 oder deren Gemische, Blends oder Legierungen. Insbesondere wird PA 1010 bevorzugt.

Bei den **Polyamiden (A1_2)** sind die Copolyamide 6I/6T, 10I/10T, 12/6T, MXD6/MXDI bevorzugt. Besonders bevorzugt sind die amorphen Copolyamide 6I/6T, 10I/10T und 12/6T mit einem Anteil von weniger als 50 Mol-% 6T-Einheiten. Bevorzugt werden insbesondere PA 6I/6T und PA 10I/10T, wobei ein Zusammensetzungsbereich T:I von 20:80 bis 45:55 bevorzugt wird. Im Hinblick auf die Copolyamide MXD6/MXDI werden MXD6 reiche Zusammensetzungen bevorzugt, insbesondere mit einem MXD6-Gehalt von grösser als 80 mol-%, besonders bevorzugt im Bereich von 82 bis 95 mol-%. Besonders bevorzugt ist Komponente (A1_2) ausgewählt als Polyamid PA 10I/10T mit einem I:T-Verhältnis im Bereich von 75:25 bis 50:50, bevorzugt im Bereich von 70:30 bis 55:45 und insbesondere von 60:40. Im Vergleich zum Copolyamid PA 6I/6T wird durch PA 10I/10T der Schwund quer zur Spritzrichtung deutlich reduziert (von 0.3% azf 0.1%).

Bezüglich einer Pohmermischung enthaltend die Polyamidkomponenten A1_1 und A1_2, werden folgende Zusammensetzungen bevorzugt:
(A1_1): PA 66 und/oder PA6
(A1_2): PA 6I/6T, wobei das Mol-Verhältnis im Bereich von 65:35 bis 75:25 liegt oder insbesondere 67:33 beträgt.
(A1_1): Mischung aus PA 6 und PA66, im Verhältnis von 1:1 bis 1:4, insbesondere im Verhältnis von 1:3 bis 1:4;
(A1_2): PA 6I/6T, wobei das Mol-Verhältnis im Bereich von 65:35 bis 75:25 liegt oder insbesondere 67:33 beträgt.
(A1_1): PA 610 und/oder PA1010, wobei im Falle einer Mischung die Komponenten im Verhältnis von 1:1 bis 4:1 eingesetzt werden.
(A1_2): PA 6I/6T, wobei das Mol-Verhältnis im Bereich von 65:35 bis 75:25 liegt oder insbesondere 67:33 beträgt.
(A1_1): PA 66
(A1_2): PA MXD6/MXDI, wobei im Copolyamid das Mol-Verhältnis im Bereich von 70:30 bis 90:10 liegt oder insbesondere 88:12 beträgt.

Dabei liegt bevorzugtermassen der Anteil der Komponente (A1_1) jeweils im Bereich von 50 bis 90 Gew.-%, insbesondere von 60 bis 85 Gew.-% und Komponente (A1_2) bevorzugt im Bereich von 10 bis 50 Gew.-%, insbesondere im Bereich von 15 bis 40 Gew.-%.

In einer besonderen Ausfuhrungsform werden folgende Zusammensetzungen für die Polyrnermischung (Polyamidmatrix) bevorzugt:
(A1_1): 55-95 Gew.-% PA 1010 oder PA 1012
(A1_2): 5-45 Gew.-% PA 6I/6T, wobei der 6I-Anteil 62-72 mol-% beträgt.
(A1_1): 55-85 Gew.-% PA 610 oder PA 612 oder PA 1010 oder PA 1012 oder PA 1210 oder PA1212 oder PA 11 oder PA 12
(A1_2): 15-45 Gew.-% PA 6T/6I oder PA 10T/10I, wobei der 6I- bzw. 10I-Anteil 55 - 80 (bevorzugt 60-75) mol-% beträgt.
(A1_1): 70-100 Gew.-%, besonders bevorzugt 70 - 90 Gew.-% einer Mischung aus PA 6 und PA66, im Verhältnis von 1:2 bis 1:4, insbesondere von 1:4
(A1_2): 0-30 Gew.-%, besonders bevorzugt 10 - 30 Gew.-% PA 6I/6T, wobei das Mol-Verhältnis im Bereich von 65:35 bis 75:25 liegt oder insbesondere 67:33 beträgt,

In einer weiteren Ausführungsform weist die Komponente A1_2 eine Glasübergangstemperatur von grösser 90°C, bevorzugt grösser 110°C und besonders bevorzugt grösser 140°C auf.

Insbesondere bevorzugt ist folgende Ausführungsform:
(A1_1): 55-85 Gew.-% PA 610 oder PA 612 oder PA 1010 oder PA 1012 oder PA 1210 oder PA1212
(A1_2): 15-45 Gew.-% PA 6T/6I oder PA 10T/10I, wobei der 6I- bzw. 101-Anteil 55 - 80 (bevorzugt 60-75) mol-% beträgt.

Bevorzugtermassen werden die Polyamide der Komponente (A1_1) ausgewählt sind aus folgender Gruppe: Polyamid 46, Polyamid 6, Polyamid 66, Polyamid 11, Polyamid 12, Polyamid 1212, Polyamid 1010, Polyamid 1012, Polyamid 1112, Polyamid 610, Polyamid 612, Polyamid 69, Polyamid 810,

Des Weiteren enthalten die Formmassen 10 bis 70 Gew.-%, bevorzugt 15 bis 60 Gew.-% und besonders bevorzugt 18 bis 55 Gew.-% faserförmige Zuschlagstoffe, vorzugsweise in Form von Glasfasern **(Komponente B),** die z.B. in Form von sogenannten Kurzfasern (z.B. Schnittglas mit einer Länge von 0.2-20 mm) oder Endlosfasern (Rovings) verwendet werden. Die Glasfasern (B) können unterschiedliche Querschnittsflächen aufweisen, wobei Glasfasern mit kreisförmigem Querschnitt (runde Fasern) und mit nicht-kreisförmigem Querschnitt (flache Fasern) bevorzugt sind.

Glasfaser mit kreisförmigem Querschnitt, also runde Glasfasern, haben einen Durchmesser im Bereich von 5-20 µm, bevorzugt im Bereich von 6-13 µm und besonders bevorzugt im Bereich von 6-10 µm. Sie werden bevorzugt als Kurzglasfaser (Schnittglas mit einer Länge von 0.2 bis 20 mm, bevorzugt 2-12 mm) eingesetzt.

Bei den flachen Glasfasern, also Glasfasern mit nicht-kreisförmiger Querschnittsfläche, werden solche mit einem Abmessungsverhältnis von der Hauptquerschnittsachse zur senkrecht darauf stehenden Nebenquerschnittsachse von mehr als 2.5, bevorzugt im Bereich von 2.5 bis 6, insbesondere im Bereich von 3 bis 5 bevorzugt eingesetzt. Diese sogenannten flachen Glasfasern weisen eine ovale, elliptische, mit Einschnürung(en) versehene elliptische (sogenannte Kokon- oder cocoon-Faser), polygonale, rechteckige oder nahezu rechteckige Querschnittsfläche auf. Ein weiteres kennzeichnendes Merkmal der eingesetzten flachen Glasfasern besteht darin, dass die Länge der Hauptquerschnittsachse bevorzugt im Bereich von 6 bis 40 µm, insbesondere im Bereich von 15 bis 30 µm und die Länge der Nebenquerschnittsachse im Bereich von 3 bis 20 µm, insbesondere im Bereich von 4 bis 10 µm liegt. Dabei weisen die flachen Glasfasern eine möglichst hohe Packungsdichte auf, d.h. die Glasquerschnittsfläche füllt ein gedachtes, den Glasfaserquerschnitt möglichst exakt umgebendes Rechteck zu mindestens 70%, bevorzugt mindestens 80% und insbesondere bevorzugt zu mindestens 85% aus.

Zur Verstärkung der erfmdungsgemässen Formmassen können auch Mischungen von Glasfasern mit kreisförmigem und nicht-kreisförmigem Querschnitt verwendet werden, wobei der Anteil an flachen Glasfasern bevorzugtermassen überwiegt, d.h. mehr als 50 Gew.-% der Gesamtmasse der Fasern ausmacht.

Vorzugsweise ist die Komponente (B) ausgewählt aus der Gruppe bestehend aus: E-Glasfasern (diese bestehen gemäss ASTM D578-00 aus 52-62% Siliciumdioxid, 12-16% Aluminiumoxid, 16-25% Calciumoxid, 0-10% Borax, 0-5% Magnesiumoxid, 0-2% Alkalioxide, 0-1.5% Titandioxid und 0-0.3% Eisenoxid; bevorzugt haben sie eine Dichte von 2.58±0.04 g/cm3, einen Zug-E-Modul von 70-75 GPa, eine Zugfestigkeit von 3000-3500 MPa und eine Reissdehnung von 4.5-4.8%), A-Glasfasern (63-72% Siliciumdioxid, 6-10% Calciumoxid, 14-16% Natrium- und Kaliumoxid, 0-6% Aluminiumoxid, 0-6% Boroxid, 0-4% Magnesiumoxid), C-Glasfasern (64-68% Siliciumdioxid, 11-15% Calciumoxid, 7-10% Natrium- und Kaliumoxid, 3-5% Aluminiumoxid, 4-6% Boroxid, 2-4% Magnesiumoxid), D-Glasfasern (72-75% Siliciumdioxid, 0-1% Calciumoxid, 0-4% Natrium- und Kaliumoxid, 0-1% Aluminiumoxid, 21-24% Boroxid), Basaltfasern (Mineralfaser mit der ungefähren Zusammensetzung: 52% SiO₂, 17% Al₂O₃, 9% CaO, 5% MgO, 5% Na₂O, 5% Eisenoxid sowie weiteren Metalloxiden), AR-Glasfasern (55-75% Siliciumdioxid, 1-10% Calciumoxid, 11-21% Natrium- und Kaliumoxid, 0-5% Aluminiumoxid, 0-8% Boroxid, 0-12%Titandioxid, 1-18% Zirkonoxid, 0-5% Eisenoxid) sowie Mischungen davon.

Eine bevorzugte Ausführungsform der Komponente (B) sind hochfeste Glasfasern beruhend auf dem ternären System Siliciumdioxid-Aluminiumoxid-Magnesiumoxid oder auf dem quaternären System Siliciumdioxid-Aluminiumoxid-Magnesiumoxid-Calciumoxid, wobei die Summe der Gehalte von Siliciumdioxid, Aluminiumoxid und Magnesiumoxid wenigstens 78 Gew.-%, bevorzugt wenigstens 87% und besonders bevorzugt wenigstens 92% bezogen auf die gesamte Glaszusammensetzung beträgt. Konkret wird bevorzugt eine Zusammensetzung von 58-70 Gew.-% Siliciumdioxid (SiO₂), 15-30 Gew.-% Aluminiumoxid (Al₂O₃), 5-15 Gew.-% Magnesiumoxid (MgO), 0-10 Gew.-% Calciumoxid (CaO) und 0-2 Gew.-% weitere Oxide, wie z.B. Zirkoniumdioxid (ZrO₂), Boroxid (B₂O₃), Titandioxid (TiO₂) oder Lithiumoxid (Li₂O) eingesetzt. In einer weiteren Ausführungsform besitzt die hochfeste Glasfaser eine Zusammensetzung von 60-67 Gew.-% Siliciumdioxid (SiO₂), 20-28 Gew.-% Aluminiumoxid (Al₂O₃), 7-12 Gew.-% Magnesiumoxid (MgO), 0-9 Gew.-% Calciumoxid (CaO) sowie 0-1.5 Gew.-% weitere Oxide, wie z.B. Zirkoniumdioxid (ZrO₂), Boroxid (B₂O₃), Titandioxid (TiO₂), Lithiumoxid (Li₂O).

Insbesondere ist bevorzugt, wenn die hochfeste Glasfaser die nachfolgende Zusammensetzung aufweist: 62-66 Gew.-% Siliciumdioxid (SiO₂), 22-27 Gew.-% Aluminiumoxid (Al₂O₃), 8-12 Gew.-% Magnesiumoxid (MgO), 0- 5Gew.-% Calciumoxid (CaO), 0-1 Gew.-% weitere Oxide, wie z.B. Zirkoniumdioxid (ZrO₂), Boroxid (B₂O₃), Titandioxid (TiO₂), Lithiumoxid (Li₂O).

Die hochfeste Glasfaser besitzt eine Zugfestigkeit von grösser oder gleich 3700 MPa, vorzugsweise von wenigstens 3800 oder 4000 MPa, eine Reissdehnung von mindestens 4.8%, vorzugsweise von wenigstens 4.9 oder 5.0 %, und einen Zug-E-Modul von grösser 75 GPa, vorzugsweise von mehr als 78 oder 80 GPa, wobei diese Glaseigenschaften an Einzelfasern (pristine single filament) mit einem Durchmesser von 10 µm und eine Länge von 12.7 mm bei einer Temperatur von 23°C und einer relativen Luftfeuchte von 50% zu bestimmen sind. Konkrete Beispiele für diese hochfesten Glasfasern der Komponente (B1) sind S-Glasfasern von Owens Corning mit 995-Schlichte, T-Glasfasern von Nittobo, HiPertex von 3B, HS4-Glasfasern von Sinoma Jinjing Fiberglass, R-Glasfaern von Vetrotex sowie S-1- und S-2-Glasfasern von AGY.

Die erfindungsgemäss z.B. als Roving eingesetzten Glasfasern (Endlosfasern) weisen einen Durchmesser (bei runden Glasfasern) bzw. eine Nebenquerschnittsachse (bei flachen Glasfasern) von 8 bis 20 µm, bevorzugt von 12 bis 18 µm auf, wobei der Querschnitt der Glasfasern rund, oval, elliptisch, elliptisch mit Einschnürung(en) versehen, polygonal, rechteckig oder nahezu rechteckig sein kann. Besonders bevorzugt werden sogenannte flache Glasfasern mit einem Verhältnis der Querschnittsachsen, d.h. ein Verhältnis von Haupt- zur Nebenquerschnittsachse von 2.5 bis 5. Die Endlosfasern können aus den oben beschriebenen Glassorten hergestellt sein, wobei Endlosfasern auf Basis von E-Glas und den hochfesten Glassorten bevorzugt sind. Diese Endlosfasern werden in die erfindungsgemässen Polyamidformmassen durch bekannte Verfahren zur Herstellung von langfaserverstärktem Stäbchengranulat eingearbeitet, insbesondere durch Pultrusionsverfahren, bei denen der endlose Faserstrang (Roving) mit der Polymerschmelze vollständig durchtränkt und anschliessend abgekühlt und geschnitten wird. Das auf diese Art und Weise erhaltene langfaserverstärkte Stäbchengranulat, das bevorzugt eine Granulatlänge von 3 bis 25 mm, insbesondere von 4 bis 12 mm aufweist, kann mit den üblichen Verarbeitungsverfahren (wie z. B. Spritzgiessen, Pressen) zu Formteilen weiterverarbeitet werden.

Bevorzugt werden als Komponente (B) Glasfasern aus E-Glas, mit nicht-kreisförmigem Querschnitt (flache Fasern) und mit einem Achsenverhältnis der Hauptquerschnittsachse zur Nebenquerschnittsachse von wenigstens 2.5, insbesondere im Bereich von 3 bis 5 und/oder hochfeste Glasfasern mit kreisförmigem oder nicht-kreisförmigem Querschnitt und einer Glaszusammensetzung, beruhend im Wesentlichen auf den Komponenten Siliciumdioxid, Aluminiumoxid und Magnesiumoxid, wobei der Anteil an Magnesiumoxid (MgO) 5-15 Gew.-% und der Anteil an Calciumoxid 0 - 10 Gew.-% beträgt.

Die Glasfasern der Komponente (B) weisen bevorzugt als flache E-Glasfasern eine Dichte von 2.54 - 2.62 g/cm³, einen Zug-E-Modul von 70 - 75 GPa, eine Zugfestigkeit von 3000 - 3500 MPa und eine Reissdehnung von 4.5 - 4.8% auf, wobei die mechanischen Eigenschaften an Einzelfasern mit einem Durchmesser von 10 µm und eine Länge von 12.7 mm bei 23°C und einer relativen Luftfeuchte von 50% bestimmt wurden.

Die erfindungsgemässen Glasfasern können mit einer für Thermoplaste, insbesondere für Polyamid geeigneten Schlichte, enthaltend einen Haftvermittler auf Basis einer Amino- oder Epoxysilanverbindung, versehen sein.

Bevorzugt liegt der Anteil an **Komponente (C)** im Bereich von 0.5-8 Gew.-%, vorzugsweise im Bereich von 1-6 Gew.-%.

Die Komponente (C) ist bevorzugt ein LDS-Additiv mit einem von Null verschiedenen Absorptionskoeffizienten für UV-, VIS- oder IR-Strahlung, welches unter Einwirkung von elektromagnetischer Strahlung, bevorzugt als Laserstrahlung, Metallkeime bildet, die in einem chemischen Metallisierverfahren die Abscheidung von Metallschichten zur Erzeugung von Leiterbahnen an den bestrahlten Stellen auf der Formteiloberfläche erleichtern und/oder ermöglichen und/oder verbessern, wobei das LDS-Additiv vorzugsweise eine Absorptionsfähigkeit im sichtbaren und infraroten Strahlungsbereich aufweist mit einem Absorptionskoeffizient von wenigstens 0.05, bevorzugt wenigstens 0.1 und insbesondere wenigstens 0.2, und/oder dass ein Absorber vorgesehen ist, der die Strahlungsenergie auf das LDS-Additiv überträgt.

Die Komponente (C) ist bevorzugt ein LDS-Additiv mit einer mittleren Partikelgrösse (D50) im Bereich von 50 - 20000 Nanometer, bevorzugt 200 bis 15000 Nanometer und besonders bevorzugt 300 bis 5000 Nanometer. Der als Mass für die Partikelgrösse angegebene D50-Wert ist ein Maß für die mittlere Teilchengröße, wobei 50 VolumenProzent der Probe feiner und die anderen 50% der Probe grober sind als der D50-Wert (Median).

Bevorzugt handelt es sich bei Komponente (C) um ein LDS (Laser Direct Structuring)-Additiv ausgewählt aus der Gruppe der Metalloxide, Metallmischoxide, Metallhydroxidoxide, Metallsulfidoxide auf Basis von Kupfer, Neodym, Molybdän, Wismut oder Zinn, wobei Spinelle, wie z.B. Kupferchromit (Kupferchromoxid, Shepard Schwarz) ausgeschlossen sind. Besonders bevorzugt sind Zinnoxid, Mischungen aus Zinn- und Antimonoxid, Wismutneodymat (Bi₂O₃·Nd₂O₃), Kupfermolybdat (CuO·xMoO₃), Mischungen aus Zinn- und Indiumoxid, Mischungen aus Zinnoxid und Zinnfluorid.

Besonders bevorzugt ist Zinnoxid und dotiertes Zinnoxid, wobei die Dotierung mit Antimon, Indium, Wismut, Molybdän, Aluminium, Titan, Silicium, Eisen, Kupfer, Silber, Nickel und Kobalt erfolgen kann. Insbesondere wird Zinnoxid, das mit Antimon, Titan oder Kupfer dotiert ist, bevorzugt. Weiterhin werden Mischungen aus Zinnoxid und mindestens einem weiteren Metalloxid, insbesondere Antimonoxid als LDS-Additive bevorzugt. Als weiteres Metalloxide werden dabei sowohl farblose hochbrechende Metalloxide, wie insbesondere Titandioxid, Antimon(III)oxid, Zinkoxid, Zinnoxid und/oder Zirkoniumdioxid verwendet als auch farbige Metalloxide wie z.B. Chromoxid, Nickeloxid, Kupferoxid, Kobaltoxid und insbesondere Eisenoxid (Fe2O3, Fe3O4). Insbesondere bevorzugt wird die Mischung aus Zinnoxid und Antimon(III)oxid verwendet.

Vorzugsweise sind die dotierten Zinnoxide bzw. Metalloxid-Mischungen bzw. Zinnoxid als Schichten auf plättchenförmigen Substraten, insbesondere Schichtsilikaten, wie z.B. synthetischer oder natürlicher Glimmer, Talkum, Kaolin, Glasplättchen oder SiO2-Plättchen, ausgebildet. Als Substrat für die Metalloxide werden insbesondere Glimmer bzw. Glimmerschuppen bevorzugt. Weiterhin kommen als Substrate auch plättchenförmige Metalloxide wie z. B. plättchenförmiges Eisenoxid, Aluminiumoxid, Titandioxid, Siliziumdioxid, LCP's (Liquid Crystal Polymers), holographische Pigmente oder beschichtete Graphitplättchen in Betracht.

Weiterhin ist Komponente (C) bevorzugt ausgewählt unter Phosphaten, kondensierten Phosphaten, Phosphonaten, Phosphiten und gemischten Hydroxid-Phosphat-Oxoanionen von Kupfer (Cu), Zinn (Sn), und/oder Eisen (Fe), insbesondere unter Metallphosphaten, basischen Metallphosphaten oder Metallhydroxidphosphaten, bevorzugt auf Basis von anorganischen Verbindungen des Kupfers und/oder Zinns, insbesondere Trizinnphosphat (CAS 15578-32-3), Trikupferphosphat (CAS 7798-23-4), Kupferdiphosphat (CAS 10102-90-6), Kupferhydroxidphosphat (CAS 12158-74-6), Kupferzinnphosphat und Gemischen davon ausgewählt.

Besonders bevorzugt werden die LDS-Additive basisches Kupferphosphat, Kupferhydroxidphosphat, Kupfer-Zinn-Phosphat, basisches Kupfer-Zinn-Phosphat, Zinnphosphat, basisches Zinnphosphat und antimondotiertes Zinnoxid, wobei Letzteres bevorzugt in Kombination mit Glimmer Verwendung findet. Besonders bevorzugt werden LDS-Additive auf Basis von Glimmer, wobei die Glimmeroberfläche mit metalldotierten Zinnoxiden beschichtet ist, weil diese eine höhere Farbhelligkeit in der Formmasse ermöglichen. Insbesondere bevorzugt wird antimondotiertes Zinnoxid.

Beispiele für kommerziell erhältliche LDS-Additive gemäss der vorliegenden Erfindung sind: Iriotec 8820, 8825, 8830 und Minatec 230 A-IR der Firma Merck, Stanostat CP40W, Stanostat CP15G, Stanostat CP5C der Firma Keeling&Walker.

Bei Komponente (C) kann es sich also um ein LDS-Additiv handeln ausgewählt aus der folgenden Gruppe: dotierte Zinnoxide, bevorzugt Antimon dotierte Zinnoxide; Metalloxid-Mischungen mit Zinnoxid, die als Schichten auf plättchenförmigen Substraten, insbesondere Schichtsilikaten, wie bevorzugt synthetischem oder natürlichem Glimmer, Talkum, Kaolin, Glasplättchen oder SiO2-Plättchen, ausgebildet sind; Metall- oder Metalloxid-dotiertes Zinnoxid; Metalloxidbeschichteter Glimmer; mit Antimon-dotiertem Zinnoxid beschichteter Glimmer; Mischung aus Zinnoxid und Antimonoxid und optional weiterer Metalloxide; Kupferchromoxid; Kupferoxid; Kupferhydroxid; Kupferhydroxidphosphat; Kupferphosphat; basische Kupferphosphate; Kupfer-Zinn-Phosphat; basisches Kupfer-Zinn-Phosphat; Zinnphosphat; basisches Zinnphosphat; oder eine Mischung solcher LDS-Additive.

Die erfmdungsgemässen Formmassen enthalten 0.1 bis 20, bevorzugt 0.5 bis 10 und besonderes bevorzugt 1 bis 8 Gew.-%, besonders bevorzugt im Bereich vom 2 - 6 Gew.-% oder 2 - 5 Gew.% anorganische Weisspigmente (**Komponente (D)**). Komponente (D) ist oder besteht ausschliesslich aus den anorganischen Weisspigmenten, ausgewählt aus der Gruppe Bariumsulfat, Zinkoxid, Zinksulfid, Lithopone, Titan-Zink-Mischoxide und Titandioxid (Rutil, Anatas), wobei die, Weisspigmente bevorzugtermassen über eine mittlere Partikelgrösse (D50) im Bereich von 0.1-40 µm, bevorzugt im Bereich von 0.1-20 µm, insbesondere im Bereich von 0.1-10 µm verfügen. Besonders bevorzugt wird Zinksulfid, besonders bevorzugt wird nur dieses als Komponente (D) verwendet. Die als Komponente D verwendeten Metalloxide sind verschieden von den Komponenten C und E.

Bevorzugt liegt der Anteil an **Komponente (E)** im Bereich von 0-18 Gew.-%, vorzugsweise im Bereich von 0-15 Gew.-% und besonders bevorzugt im Bereich von 2 - 15 Gew.-% oder 3 - 10 Gew-%. Talk, Kreide oder Calciumcarbonat beispielsweise können die Erzeugung von Metallkeimen erleichtern.

Als partikuläre Füllstoffe der Komponente (D) kommen alle dem Fachmann bekannten Füllstoffe in Frage. Hierzu zählen insbesondere partikuläre Füllstoffe ausgewählt aus der Gruppe bestehend aus Talk (Magnesiumsilikat), Glimmer, Silikaten, Quarz, Wollastonit, Kaolin, Kieselsäuren, Magnesiumcarbonat, Magnesiumhydroxid, Kreide, gemahlenem oder gefälltem Calciumcarbonat, Kalk, Feldspat, anorganische Pigmente verschieden von Komponente C und D, wie z.B., Eisenoxid oder Eisenmanganoxid, permanentmagnetischen oder magnetisierbaren Metallen oder Legierungen, hohlkugeligen Silikatfüllstoffen, Aluminiumoxid, Bornitrid, Borcarbid, Aluminiumnitrid, Calciumfluorid und Mischungen hiervon. Die Füllstoffe können auch oberflächenbehandelt sein.

Diese Füllstoffe (Komponente E) haben eine mittlere Partikelgrösse (D50) im Bereich von 0.1-40 µm, bevorzugt im Bereich von 0.2-20 µm, insbesondere im Bereich von 0.3-10 µm. Bevorzugt wird eine Form der partikulären Füllstoffe, bei denen die Aspektverhältnisse L/b1 und L/b2 beide höchstens 10, insbesondere höchstens 5 sind, wobei die Aspektverhältnisse durch die Quotienten aus grösster Länge L des Teilchens zu dessen mittleren Breite b1 oder b2 beschrieben werden. Dabei liegen b1 und b2, die senkrecht zueinander angeordnet sind, in einer zur Länge L senkrechten Ebene.

Zudem können die erfindungsgemäßen thermoplastischen Polyamidformmassen weiterhin übliche und dem Fachmann allgemein bekannte Zusatzstoffe in Form der **Additive (F)** enthalten, die bevorzugt aus der Gruppe bestehend aus: Haftvermittlern, Stabilisatoren, Alterungsschutzmitteln, Antioxidantien, Antiozonantien, Lichtschutzmitteln, UV-Stabilisatoren, UV-Absorbern, UV-Blockern, anorganischen Hitzestabilisatoren, insbesondere auf Basis von Kupferhalogeniden und Alkalihalogeniden, organischen Hitzestabilisatoren, Leitfähigkeitsadditiven, Russ, optischen Aufhellern, Verarbeitungshilfsmitteln, Nukleierungsmitteln, Kristallisationsbeschleunigern, Kristallisationsverzögerern, Fliesshilfsmitteln, Gleitmitteln, Entformungsmitteln, Weichmachern, organischen Pigmenten und Farbstoffen, Markierungsstoffen und Mischungen hiervon ausgewählt sind.

Des Weiteren betrifft die Erfindung ein Bauteil, insbesondere Bauteil mit elektrischen Leiterbahnen, auf Basis einer Formmasse wie oben dargestellt. Einsatzgebiete für die MID-Technologie sind der Automobilbau, die Industrieautomation, die Medizintechnik, die Hausgeräteindustrie, Unterhaltungselektronik, die Telekommunikationstechnik, die Mess- und Analysetechnik, Maschinenbau, sowie Luft- und Raumfahrt. Die Erfindung betrifft damit auch einen Artikel, insbesondere einen Schaltungsträger, enthaltend ein Formteil, hergestellt aus der erfindungsgemässen Formmasse. In einer Ausführungsform wird der Schaltungsträger genutzt, um eine Antenne auszubilden. Solche Formteile sind beispielsweise Gehäuse oder Gehäuseteile für tragbare elektronische, wie z.B. PDAs, Mobiltelefone, andere Telekommunikations-Geräte, Gehäuse oder Gehäuseteile für Personal Computer, Notebooks, medizinische Geräte, wie z.B. Hörgeräte, Sensortechnik, oder RFID (Radio Frequency IDentification) Transponder oder Teile für den Automobilbereich, wie z.B. Airbagmodul, Multifunktionslenkrad.

Aufgrund der umfangreichen Gestaltungsmöglichkeiten beim Kunststoffspritzgiessen können dreidimensionale Schaltungsträger realisiert werden. Darüber hinaus können typische mechanische Funktionen wie Halter, Führungen, Taster, Stecker oder andere Verbindungselemente integriert werden. Ebenfalls möglich sind Konnektoren für E/E und für Kraftstoffsysteme.

Weitere Ausführungsformen sind in den abhängigen Ansprüchen angegeben.

### KURZE BESCHREIBUNG DER ZEICHNUNGEN

Bevorzugte Ausführungsformen der Erfindung werden im Folgenden anhand der Zeichnungen beschrieben, in den Zeichnungen zeigen:
- Fig. 1: die Parameter der Laserstrukturierung; und
- Fig. 2: eine Musterplatte nach Laseraktivierung und Metallisierung.

### BESCHREIBUNG BEVORZUGTER AUSFÜHRUNGSFORMEN

Die Erfindung soll nachfolgend unter Verwendung von spezifischen Ausführungsbeispielen (B) beschrieben und mit den weniger leistungsfähigen Systemen nach dem Stand der Technik (VB) verglichen werden. Die in der Folge angegebenen Ausführungsbeispiele dienen zur Stützung der Erfindung und zum Nachweis der Unterschiede zum Stand der Technik, sie sollen aber nicht zur Einschränkung des allgemeinen Gegenstandes der Erfindung, wie er in den Patentansprüchen definiert ist, hinzugezogen werden.

### Beispiele B1 bis B9 und Vergleichsbeispiele VB1 bis VB6

Die in den Tabellen 2 und 3 angegebenen Komponenten werden in einem zweiwelligen Extruder der Firma Werner und Pfleiderer mit einem Schneckendurchmesser von 25 mm bei vorgegebenen Prozessparametern (vgl. Tabelle 1) compoundiert. Dabei werden die Polyamidgranulate sowie die Zusatzstoffe in die Einzugszone dosiert, während die Glasfaser über einen Sidefeeder 3 Gehäuseeinheiten vor der Düse in die Polymerschmelze dosiert wird. Die Compounds wurden als Strang aus einer Düse mit 3 mm Durchmesser abgezogen und nach Wasserkühlung granuliert. Das Granulat wurde 24 Stunden bei 110°C im Vakuum von 30 mbar getrocknet. Die Compounds werden mit einer Spritzgussmaschine Arburg Allrounder 320-210-750 zu Probekörpern bei definierten Zylindertemperaturen der Zonen 1 bis 4 und einer definierten Werkzeugtemperatur (siehe Tabelle 1) verspritzt.

**Tabelle 1: Compoundier- und Spritzgussbedingungen für die Beispiele und Vergleichsbeispiele**

| **Compoundier-/Verarbeitungsparameter** | | **B1**-**B9**, **VB1**-**VB6** |
|---|---|---|
| Compoundierung | Zylindertemperaturen [°C] | 250-280 |
| | Schneckendrehzahl [Upm] | 200 |
| | Durchsatz [kg/h] | 15 |
| Spritzguss | Zylindertemperaturen [°C] | 280 |
| | Werkzeugtemperatur [°C] | 80 |

**Tabelle 2: Zusammensetzung und Eigenschaften der Beispiele B1 bis B8**

| | Einheit | **B1** | **B2** | **B3** | **B4** | **B5** | **B6** | **B7** | **B8** |
|---|---|---|---|---|---|---|---|---|---|
| ***Zusammensetzung*** | | | | | | | | | |
| PA1010 | Gew.-% | 35.5 | 35.7 | 34.0 | 35.5 | 34.2 | 34.2 | 34.2 | 34.2 |
| PA 6I/6T | Gew.-% | 11.8 | 11.9 | 11.3 | | 8.5 | 8.5 | 8.5 | 8.5 |
| PA 10I/10T | Gew.-% | | | | 11.8 | | | | |
| Glasfaser Typ B | Gew.-% | 50 | 50 | 50 | 50 | 50 | 50 | 50 | 50 |
| LDS-Additiv 1 | Gew.-% | 1.4 | 1.0 | 1.4 | 1.4 | 4 | 4 | | |
| LDS-Additiv 3 | | | | | | | | 4 | 4 |
| Zinksulfid | Gew.-% | 1.0 | 1.1 | 3.0 | 1.0 | 3 | | 3 | |
| Titandioxid | Gew.-% | | | | | | 3 | | 3 |
| Irganox 1098 | Gew.-% | 0.3 | 0.3 | 0.3 | 0.3 | 0.3 | 0.3 | 0.3 | 0.3 |

| ***Eigenschaften*** | | | | | | | | | |
|---|---|---|---|---|---|---|---|---|---|
| Zug-E-Modul | MPa | 14'500 | 14'300 | 14'800 | 12'500 | 16'000 | 15'000 | 15'800 | 14'700 |
| Reissfestigkeit | MPa | 183 | 182 | 182 | 134 | 185 | 146 | 175 | 140 |
| Reissdehnung | % | 2.7 | 2.7 | 2.6 | 3.5 | 2.2 | 1.7 | 2.1 | 1.7 |
| Schlagzähigkeit 23°C | kJ/m² | 82 | 85 | 81 | 83 | 64 | 42 | 57 | 46 |
| Kerbschlagzähigke it 23°C | kJ/m² | 17 | 17 | 15 | 20 | 15 | 8 | 12 | 10 |
| Metallisierbarkeit (Anteil metallisierte Felder) | % | 97 | 91 | 97 | 97 | 100 | 100 | 88 | 91 |
| Farbe (subjektiver Farbeindruck) | | weiss | weiss | weiss | weiss | weiss | weiss | weiss (grün) | weiss |
| Farbhelligkeit L* | | 72 | 73 | 79 | 76 | 80 | 82 | 70 | 75 |

**Tabelle 3: Zusammensetzung und Eigenschaften der Vergleichsbeispiele VB1 bis VB6 und B9**

| | Einheit | **VB1** | **VB2** | **VB3** | **VB4** | **VB5** | **VB6** | **B9** |
|---|---|---|---|---|---|---|---|---|
| ***Zusammensetzung*** | | | | | | | | |
| PA1010 | Gew.-% | 36.6 | 36.6 | 36.6 | 52.4 | 44.4 | 34.2 | 42.7 |
| PA 6I/6T | Gew.% | 9.1 | 9.1 | 9.1 | 13.3. | 11.3 | 8.5 | |
| LDS-Additiv 1 | Gew.-% | | | | | | | 4 |
| LDS-Additiv 2 | Gew.% | 4 | 4 | 4 | 4 | 4 | 4 | |
| Glasfaser Typ A | Gew.-% | | 50 | | | | | |
| Glasfaser Typ B | Gew.% | 50 | | | 30 | 30 | 50 | 50 |
| Glasfaser Typ C | Gew.% | | | 50 | | | | |
| Zinksulfid | Gew.% | | | | | | | 3 |
| Titandioxid | Gew.% | | | | | | 3 | |
| Talkum | Gew.-% | | | | | 10 | | |
| Irganox 1098 | Gew.-% | 0.3 | 0.3 | 0.3 | 0.3 | 0.3 | 0.3 | 0.3 |

| ***Eigenschaften*** | | | | | | | | |
|---|---|---|---|---|---|---|---|---|
| Zug-E-Modul | MPa | 14'400 | 14'300 | 16'100 | 8'300 | 11'000 | 14000 | 15'600 |
| Reissfestigkeit | MPa | 145 | 146 | 167 | 111 | 122 | 116 | 178 |
| Reissdehnung | % | 1.9 | 2.2 | 2.4 | 2.5 | 1.9 | 1.5 | 2.2 |
| Schlagzähigkeit 23°C | kJ/m² | 58 | 56 | 58 | 42 | 38 | 32 | 68 |
| Kerbschlagzähigkei t 23°C | kJ/m² | 11 | 10 | 11 | 9 | 8 | 7 | 16 |
| Metallisierbarkeit (Anteil metallisierte Felder) | % | 100 | 100 | 100 | 100 | 100 | 100 | 91 |
| Farbe (subjektiver Farbeindruck) | | schwarz | schwarz | schwarz | schwarz | schwarz | grau | weiss |
| Farbhelligkeit L* | | 31 | 31 | 32 | 31 | 32 | 42 | 82 |

### Legende, Materialien:

- PA 6I/6T (70:30): Amorphes, teilaromatisches Polyamid auf Basis von Terephthalsäure, Isophthalsäure und 1,6-Hexandiamin, mit einer Glasübergangstemperatur von 125°C und einer Lösungsviskosität von 1.54.
- PA 10I/10T (60:40): Amorphes, teilaromatisches Polyamid auf Basis von 1,10-Decandiamin, Isophthalsäure und Terephthalsäure, mit einer Glasübergangstemperatur von 101 °C und einer Lösungsviskosität von 1.59.
- PA 1010: Teilkristallines, aliphatisches Polyamid auf Basis von 1,10-Decandiamin und Sebacinsäure, mit einem Schmelzpunkt von 200°C und einer Lösungsviskosität von 1.78.
- Glasfaser Typ A: Schnittglasfasern Vetrotex 995 aus E-Glas, mit einer Länge von 4.5 mm und einem Durchmesser von 10 µm (kreisförmiger Querschnitt) von Owens Corning Fiberglas
- Glasfaser Typ B: Schnittglasfasern CSG3PA-820 aus E-Glas, mit einer Länge von 3 mm, einer Hauptquerschnittsachse von 28 µm, einer Nebenquerschnittsachse von 7 µm und einem Achsenverhältnis von 4 (nicht-kreisförmiger Querschnitt) von NITTO BOSEKI, Japan
- Glasfaser Typ C:: GF O.C. HPXSS PAX95 10-4 (Owens Corning (US)
- LDS-Additiv 1: Iriotec 8825, Zinn- und Antimonoxid auf Glimmer, Merck
- LDS-Additiv 2: Kupferchromit, (Shepherd)
- LDS-Additiv 3: Metallphosphat auf Zinnbasis, Fabulase 330 (Budenheim)
- Titandioxid: Titandioxid KRONOS 2222 , White pigment. >92.5% titanium dioxide. Rutile. Coating: Al, Si, polysiloxane. d₅₀ 0.21µm. D 4.0g/cm³.
- Zinksulfid: Zinksulfid Sachtolith HD-S (Sachtleben), mittlere Partikelgrösse im Bereich von 0.30 bis 0.35 µm.
- Talkum: Microtalc IT Extra Mondo Minerals

Die Messungen wurden nach folgenden Normen und an folgenden Prüfkörpern durchgeführt.

### (Thermo-) Mechanische Parameter:

Der Zug-E-Modul wurde nach ISO 527 mit einer Zuggeschwindigkeit von 1 mm/min, die Streckspannung, die Reissfestigkeit und die Reissdehnung wurden bestimmt gemäss ISO 527 mit einer Zuggeschwindigkeit von 5 mm/min (unverstärkte Varianten) oder einer Zuggeschwindigkeit von 5 mm/min (verstärkte Varianten) bei einer Temperatur von 23 °C, wobei als Probekörper ein ISO-Zugstab , Norm: ISO/CD 3167, Typ Al, 170 x 20/10 x 4 mm, verwendet wurde.

Schlagzähigkeit und Kerbschlagzähigkeit nach Charpy wurden nach ISO 179 am ISO-Prüfstab, Norm: ISO/CD 3167, Typ B1, 80 x 10 x 4 mm bei Temperatur 23 °C gemessen.

Das thermische Verhalten (Schmelztemperatur (Tₘ), Schmelzenthalpie (ΔHₘ), Glasumwandlungstemperatur (Tg)) wurde anhand der ISO-Norm 11357-11-2 am Granulat bestimmt. Die Differential Scanning Calorimetry (DSC) wurde mit Aufheizrate von 20 °C/min durchgeführt. Für die Glasumwandlungstemperatur (Tg) wird die Temperatur für die Mittelstufe bzw. den Wendepunkt angegeben.

Die relative Viskosität (ηᵣₑₗ) wurde gemäss DIN EN ISO 307 anhand von 0,5 Gew.-%-igen m-Kresollösungen bei 20 °C gemessen. Als Probe wird Granulat verwendet.

Die Wärmeformbeständigkeit in Form von HDT A (1,8 MPa) und HDT B (0.45 MPa) wurden gemäss ISO 75 an ISO-Schlagstäben der Dimension 80x10x4 mm bestimmt.

### Laserstrukturierbarkeit:

Zur Beurteilung des Metallisierungsverhaltens wurden spritzgegossene Formteile (Platte 60 x 60 x 2 mm) mit Hilfe eines Nd:YAG-Lasers strukturiert und nachfolgend stromlos im Verkupferungsbad metallisiert. Bei der Laserstrukturierung wurden auf der Formteiloberfläche 18 nebeneinanderliegende, 4 x 4 mm grosse Bereiche bestrahlt. Die Laserstrukturierung erfolgte mittels eines Trumpf TruMark Station 5000 Lasers bei einer Wellenlänge von 1064 nm bei einer Geschwindigkeit im Bereich von 300 bis 7200 mm.

Dabei wurde sowohl die Pulsfrequenz als im Bereich von 10 - 80 kHz und der Hatch (Überlappung der Pulse) im Bereich von 0.03 bis 0.09 mm variiert. Im Anschluss an die Laserstrukturierung werden die Formteile einem Reinigungsprozess zur Entfernung der Rückstände des Laserprozesses unterworfen. Die Formteile durchlaufen dabei nacheinander Ultraschallbäder mit Tensid und deionisiertem Wasser. Die gereinigten Formteile werden sodann nacheinander in reduktiven Verkupferungsbädern (MID Copper 100 XB Strike und MID Copper 100 XB Build, Mac Dermid) bei 55 bis 65°C metallisiert.

Dabei beträgt die Aufenthaltszeit im Strike-Bad 20 min und im Build-Bad 1-3 h. Die Kupferabscheidungsrate (Dicke der Kupferschicht) im MID Copper 100 XB Build Bad auf den vom Laser bestrahlten Flächen beträgt durchschnittlich 3 bis 5 µm/h.

### Metallisierbarkeit:

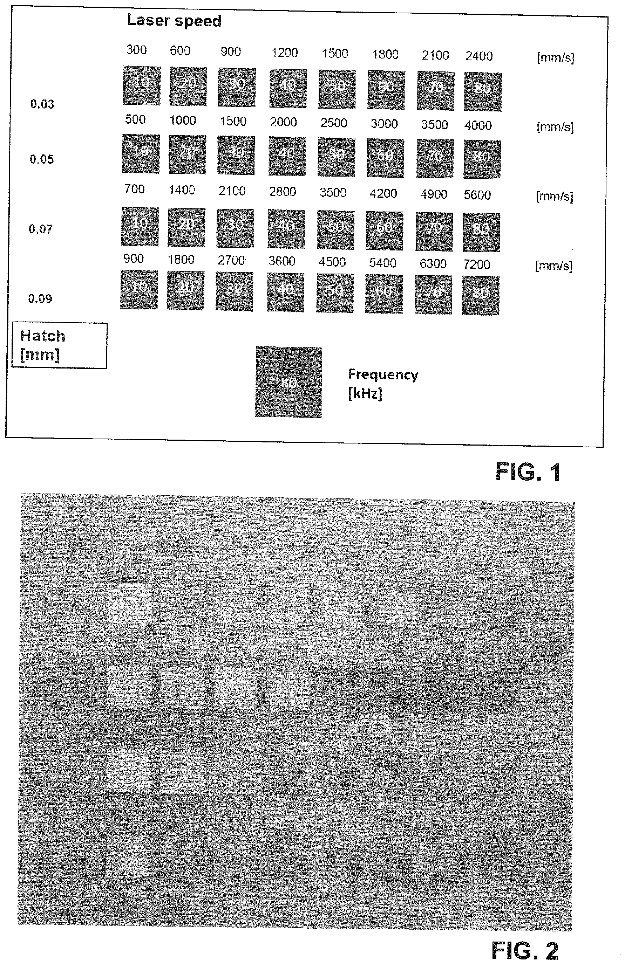

Die Metallisierbarkeit wurde als der Quotient aus metallisierten Feldern zur Gesamtzahl der Felder berechnet. Insgesamt werden pro Probenplatte 32 Felder mit unterschiedlichen Parametern, wie in Fig. 1 gezeigt, mit dem Laser strukturiert und nachfolgend wie oben beschrieben metallisiert. Metallisierte Felder sind nur solche Felder, die in oben beschriebenen Prozess vollständig und gleichmässig metallisiert wurden. In Fig. 2 wird eine Probenplatte nach Laserstrukturierung und Metallisierung gezeigt, bei der die Felder unterhalb der Diagonalen von links unten nach rechts oben nicht oder unzureichend, d.h. unvollständig oder ungleichmässig metallisiert sind.

Die chemisch-reduktive Kupferabscheidung ist bei allen moulded interconnect device (MID)-Technologien der entscheidende Startmetallisierungsprozess, der über die Qualität der Gesamtschicht entscheidet. Deshalb ist es völlig ausreichend, die Qualität der Primärmetallschicht zu beurteilen. Um zum fertigen MID-Teil zu kommen, werden aufbauend auf der ersten Kupferschicht (Primärschicht) in der Regel Nickel und anschliessend eine Endschicht aus Tauchgold abgeschieden. Selbstverständlich können auch andere Metallschichten, wie z.B. weitere Kupfer-, Palladium-, Zinn- oder Silberschichten auf die Primärschicht aufgebracht werden.

### Farbhelligkeit L*:

Die CIE L*a*b*-Werte (DIN 6174) von Probenkörper der Dimension 2x40x50 mm (Farbplättchen) wurden mit einem Spectrophotometer der Firma Datacolor (Gerätebezeichnung: Datacolor 650) unter den folgenden Messbedingungen vor einem weisslackierten Kontrastblech bestimmt; Messmodus: Reflexion, Messgeometrie: D/8°, Lichtart: D 65 10, Glanz: eingeschlossen, Kalibrierung: UV-kalibriert, Messblende: SAV. Die für die Farbmessung verwendeten Farbplättchen wurden aus den Materialien der Beispiele und Vergleichsbeispiele auf einer vollelektrischen Spritzgussmaschine der Firma Arburg (Gerätebezeichnung: ARBURG Allrounder 320 A 500-170) mit temperiertem Werkzeug gespritzt. Die Spritzgussparameter sind in Tabelle 1 aufgeführt.

Die erfindungsgemässen Beispiele, bei denen das LDS-Additiv 1 oder 3 verwendet wurde, haben deutlich bessere mechanische Eigenschaften, insbesondere eine höhere Reissfestigkeit, Reissdehnung, Schlagzähigkeit und Kerbschlagzähigkeit, als die unter Einsatz des LDS-Additivs 1 herstellten Vergleichsversuche, insbesondere bei gleichzeitiger Verwendung von Weisspigmenten, wie der Vergleich von B6 mit VB6 zeigt. Parallel dazu weisen die erfindungsgemässen Formmassen eine gleiche oder ähnlich gute Metallisierbarkeit auf und haben eine hellere Eigenfarbe, was sich in deutlich höheren Farbhelligkeitswerten L* widerspiegelt. So wird für VB6 eine Metallisierbarkeit von 100% und eine Farbhelligkeit L* von 42 bestimmt, während für B6 die Metallisierbarkeit ebenfalls bei 100% liegt, die Farbhelligkeit aber mit 82 einen deutlich höheren Wert annimmt. Vergleicht man B5 mit B6 und B7 mit B8 erkennt man, dass bei gleichem LDS-Additiv unter Verwendung von Zinksulfid als Weisspigment anstatt Titandioxid durchweg bessere mechanische Eigenschaften resultieren.

## Patentansprüche

1. Thermoplastische Formmasse bestehend aus:
(A) 20 - 88 Gew.-% einer Mischung bestehend aus
(A1) 60-100 Gew.-% eines thermoplastischen Kunststoffes oder einer Mischung thermoplastischer Kunststoffe bestehend aus
(A1_1) 40 - 100 Gew.-% aliphatischem Polyamid
(A1_2) 0 - 60 Gew.-% amorphem, teilaromatischem Polyamid
wobei sich die Summe der Komponenten (A1_1) und (A1_2) auf 100 Gew.-% der Komponente (A1) ergänzt;
(A2) 0 - 40 Gew.-% einer Mischung aus
(A2_1) 0 - 40 Gew.-% eines thermoplastischen Kunststoffes verschieden von (A1) oder einer Mischung thermoplastischer Kunststoffe verschieden von (A1);
(A2_2) 0 - 40 Gew.-% Schlagzähmodifier verschieden von (A1) und (A2_1);
wobei sich die Summe der Komponenten (A1), (A2_1) und (A2_2) auf 100 Gew.-% der Komponente (A) ergänzt;
(B) 10 - 70 Gew.-% faserförmigen Zuschlagstoffen;
(C) 0.1 - 10 Gew.-% eines Laser Direct Structuring (LDS)-Additivs oder einer Mischung von Laser Direct Structuring-Additiven, wobei mindestens ein Laser Direct Structuring-Additiv ausgewählt ist aus der folgenden Gruppe: Metalloxid auf Basis von Kupfer, Indium, Neodym, Molybdän, Wismut oder Zinn oder Mischungen davon, mit der Massgabe, dass Spinelle ausgeschlossen sind; Metallphosphat; Metallhydroxidphosphat;
(D) 0.1 - 20 Gew.-% Weisspigment;
(E) 0 - 20 Gew.-% partikulärer Füllstoff, verschieden von C und/oder D;
(F) 0 - 2 Gew.-% weitere andere Additive;
wobei die Summe aus (A) - (F) 100 Gew.-% ausmacht.

2. Formmasse nach Anspruch 1, **dadurch gekennzeichnet, dass** die aliphatischen Polyamide der Komponente (A1_1) ausgewählt sind aus der Gruppe bestehend aus: Polyamid 11, Polyamid 12, Polyamid 1212, Polyamid 1010, Polyamid 1012, Polyamid 1112, Polyamid 610, Polyamid 612, Polyamid 69, Polyamid 810 oder deren Gemische, Blends oder Legierungen, wobei PA 1010 besonders bevorzugt ist.

3. Formmasse nach einem der vorhergehenden Ansprüche, **dadurch gekennzeichnet, dass** die Komponente (A2_1) ausgewählt ist aus der Gruppe bestehend aus: Polyamid, Polycarbonat, Polystyrol, Polymethylmethacrylat, Acrylnitril-Butadien-Styrol-Copolymerisat, Acrylnitril-Styrol-Copolymer, Polyolefin, Polyoxymethylen, Polyester, insbesondere Polyethylenterephthalat, Polybutylenterephthalat, Polysulfon, insbesondere des Typs PSU, PESU, PPSU, Polyphenylenether, Polyphenylensulfid, Polyphenylenoxid, flüssigkristalline Polymere, Polyetherketon, Polyetheretherketon, Polyimid, Polyamidimid, Polyesterimid, Polyetheramid, Polyesteramid, Polyetheresteramid, Polyurethan, insbesondere des Typs TPU, PUR, Polysiloxan, Polyacrylat, Polymethacrylat sowie Mischungen oder Copolymere auf Basis solcher Systeme.

4. Formmasse nach einem der vorhergehenden Ansprüche, **dadurch gekennzeichnet, dass** der Anteil der Komponente (A2_1), im Bereich von 5-40 Gew.-% liegt, oder im Bereich von 5-30 Gew.-% oder im Bereich von 5-20 Gew.-%, jeweils bezogen auf die Summe der Komponenten (A1), (A2_1) und (A2_2).

5. Formmasse nach einem der vorhergehenden Ansprüche, **dadurch gekennzeichnet, dass** die Komponente (A2_2) ausgewählt ist aus der Gruppe bestehend aus: Olefinpolymere, niedrig-, mittel- und hochdichte Polyethylene, Polypropylen, Polybutadien, Poly-4-methylpenten, Ethylen-Propylen-Block- oder statistische Copolymere, Ethylen-Methylhexadien-Copolymere, Propylen-Methylhexadien-Copolymere, Ethylen-Propylen-Buten-Copolymere, Ethylen-Propylen-Hexen-Copolymere, Ethylen-Propylen-Methylhexadien-Copolymere, Poly(ethylenvinylacetat) (EVA), Poly(ethylen-ethylacrylat) (EEA), Ethylen-Octen-Copolymer, Ethylen-Buten-Copolymer, Ethylen-Hexen-Copolymer, Ethylen-Propylen-Dien-Terpolymere sowie Kombinationen der genannten Polymere, bevorzugt funktionalisiert mit Säureanhydridgruppen,
und/oder dass der Anteil der Komponente (A2_2), im Bereich von 5-40 Gew.-% liegt, oder im Bereich von 5-30 Gew.-% oder im Bereich von 5-20 Gew.-%, jeweils bezogen auf die Summe der Komponenten (A1), (A2_1) und (A2_2).

6. Formmasse nach einem der vorhergehenden Ansprüche, **dadurch gekennzeichnet, dass** die Komponente (A1) aus aliphatischem Polyamid besteht oder aus einer Polyamidmischung, welche mindestens 60 Gew.-% aliphatisches Polyamid, oder 60 bis 93 Gew.-% aliphatisches Polyamid enthält, jeweils bezogen auf die Gesamtmenge der Komponente (A1).

7. Formmasse nach einem der vorhergehenden Ansprüche, **dadurch gekennzeichnet, dass** der Anteil an Komponente (A) im Bereich von 25-84 Gew.-% liegt, oder im Bereich von 30-80 Gew.-%, wobei vorzugsweise die Komponente (A) ausschliesslich durch die Komponente (A1) in Form eines Polyamides oder einer Mischung von Polyamiden gebildet wird.

8. Formmasse nach einem der vorhergehenden Ansprüche, **dadurch gekennzeichnet, dass** der Anteil an Komponente (B) im Bereich von 15-60 Gew.-% liegt, oder im Bereich von 18-55 Gew.-%,
und/oder dass die Glasfasern der Komponente (B) in Form von Kurzfasern, bevorzugt in Form von Schnittglas mit einer Länge im Bereich von 0.2-20 mm, oder in Form von oder Endlosfasern vorliegen.

9. Formmasse nach einem der vorhergehenden Ansprüche, **dadurch gekennzeichnet, dass** die Komponente (B) durch Glasfasern gebildet wird, vorzugsweise als E-Glasfasern gemäss ASTM D578-00 mit nicht-kreisförmigem Querschnitt, wobei das Abmessungsverhältnis von der Hauptquerschnittsachse zur senkrecht darauf stehenden Nebenquerschnittsachse mehr als 2.5 beträgt, bevorzugt im Bereich von 2.5 bis 6, insbesondere im Bereich von 3 bis 5 liegt,
vorzugsweise aus 52-62% Siliciumdioxid, 12-16% Aluminiumoxid, 16-25% Calciumoxid, 0-10% Borax, 0-5% Magnesiumoxid, 0-2% Alkalioxide, 0-1.5% Titandioxid und 0-0.3% Eisenoxid, oder
vorzugsweise die Glasfasern der Komponente (B) als hochfeste Glasfasern beruhend auf dem ternären System Siliciumdioxid-Aluminiumoxid-Magnesiumoxid oder auf dem quaternären System Siliciumdioxid-Aluminiumoxid-Magnesiumoxid-Calciumoxid sind, wobei sie die folgende Zusammensetzung aufweisen: 58-70 Gew.-%, bevorzugt 60-67 Gew.-% Siliciumdioxid (SiO₂), 15-30 Gew.-%, bevorzugt 20-28 Gew.-% Aluminiumoxid (Al₂O₃), 5-15 Gew.-%, bevorzugt 7-12 Gew.-% Magnesiumoxid (MgO), 0-10 Gew.-%, bevorzugt 0-9 Gew.-% Calciumoxid (CaO) und 0-2 Gew.-%, bevorzugt 0-1.5 Gew.-% weitere Oxide, wie insbesondere Zirkoniumdioxid (ZrO₂), Boroxid (B₂O₃), Titandioxid (TiO₂) oder Lithiumoxid (Li₂O) oder eine Kombination dieser Oxide, ausgewählt sind.

10. Formmasse nach einem der vorhergehenden Ansprüche, **dadurch gekennzeichnet, dass** der Anteil an Komponente (C) im Bereich von 0.5-8 Gew.-% liegt, oder im Bereich von 1-6 Gew.-%.

11. Formmasse nach einem der vorhergehenden Ansprüche, **dadurch gekennzeichnet, dass** die Komponente (C) ein Laser Direct Structuring-Additiv mit einer durchschnittlichen Partikelgrösse (d₅₀) im Bereich von 50 - 20000 Nanometer, oder 200 bis 15000 Nanometer oder 300 bis 5000 Nanometer ist.

12. Formmasse nach einem der vorhergehenden Ansprüche, **dadurch gekennzeichnet, dass** es sich bei Komponente (C) um ein Laser Direct Structuring-Additiv handelt ausgewählt aus der folgenden Gruppe: Metall- oder Metalloxid-dotierte Zinnoxide, bevorzugt Antimon oder Antimonoxid dotierte Zinnoxide; Metalloxid-Mischungen mit Zinnoxid, die als Schichten auf plättchenförmigen Substraten, insbesondere Schichtsilikaten, wie bevorzugt synthetischem oder natürlichem Glimmer, Talkum, Kaolin, Glasplättchen oder SiO₂-Plättchen, ausgebildet sind;; mit Antimon-dotiertem Zinnoxid beschichteter Glimmer; Mischung aus Zinnoxid und Antimonoxid und/oder Indiumoxid und/oder Zinkfluorid; Kupferoxid; Kupferhydroxid; Kupferhydroxidphosphat; Kupferphosphat; basische Kupferphosphate; Kupfer-Zinn-Phosphat; basisches Kupfer-Zinn-Phosphat; Zinnphosphat; basisches Zinnphosphat; oder eine Mischung solcher Laser Direct Structuring-Additive.

13. Formmasse nach einem der vorhergehenden Ansprüche, **dadurch gekennzeichnet, dass** der Anteil an Komponente (D) im Bereich von 0.5-20 Gew.-% liegt, oder im Bereich von 5 - 10, oder im Bereich von 1-8 Gew.-%, oder im Bereich vom 2 - 6 Gew.-% oder 2 - 5 Gew.%,
und/oder dass Komponente (D) ausgewählt ist aus der folgenden Gruppe: Bariumsulfat; Titandioxid, in der Rutil oder der Anatas-Modifikation; Zinkoxid; Lithopone; Titan-Zink-Mischoxide; Zinksulfid; oder eine Mischung davon, insbesondere Zinksulfid, wobei vorzugsweise die Komponente (D) ausschliesslich durch Zinksulfid gebildet wird.

14. Formmasse nach einem der vorhergehenden Ansprüche, **dadurch gekennzeichnet, dass** der Anteil an Komponente (E) im Bereich von 0-18 Gew.-% liegt, oder im Bereich von 0-15 Gew.-%, oder im Bereich vom 2 - 15 Gew.-% oder 3 - 10 Gew.-%.

15. Bauteil, insbesondere Bauteil mit elektrischen Leiterbahnen, auf Basis einer Formmasse nach einem der vorhergehenden Ansprüche, bevorzugt als Gehäuse oder Gehäuseteil für tragbare elektronische Geräte, wie insbesondere PDAs, Mobiltelefone, Telekommunikations-Geräte, Gehäuse oder Gehäuseteile für Personal Computer, Notebooks, medizinische Geräte, wie insbesondere Hörgeräte, Sensortechnik, oder Radio Frequency IDentification (RFID) Transponder oder Teile für den Automobilbereich, wie insbesondere Airbagmodul, und Multifunktionslenkrad.

## Claims

1. Thermoplastic moulding composition consisting of:
(A) 20-88 wt% of a mixture consisting of
(A1) 60-100 wt% of a thermoplastic or of a mixture of thermoplastics consisting of
(A1_1) 40-100 wt% of aliphatic polyamide
(A1_2) 0-60 wt% of amorphous, partially aromatic polyamide,
the sum of components (A1_1) and (A1_2) adding up to 100 wt% of component (A1);
(A2) 0-40 wt% of a mixture of
(A2_1) 0-40 wt% of a thermoplastic other than (A1), or of a mixture of thermoplastics other than (A1);
(A2_2) 0-40 wt% of impact modifiers other than (A1) and (A2_1);
the sum of components (A1), (A2_1) and (A2_2) adding up to 100 wt% of component (A);
(B) 10-70 wt% of fibrous adjuvants;
(C) 0.1-10 wt% of an laser direct structuring (LDS) additive or of a mixture of laser direct structuring additive additives, at least one laser direct structuring additive additive being selected from the following group: metal oxide based on copper, indium, neodymium, molybdenum, bismuth or tin or mixtures thereof, with the proviso that spinels are excluded; metal phosphate; metal hydroxide phosphate;
(D) 0.1-20 wt% of white pigment;
(E) 0-20 wt% of particulate filler other than C and/or D;
(F) 0-2 wt% of further, different additives;
the sum of (A) - (F) making up 100 wt%.

2. Thermoplastic moulding composition according to Claim 1, **characterized in that** the aliphatic polyamide (A1_1) is selected from the group consisting of: polyamide 11, polyamide 12, polyamide 1212, polyamide 1010, polyamide 1012, polyamide 1112, polyamide 610, polyamide 612, polyamide 69, polyamide 810, or their mixtures, blends or alloys, wherein polyamide 1010 is particularly preferred..

3. Moulding composition according to either of the preceding claims, **characterized in that** (A2_1) is selected from the group consisting of the following: polyamide, polycarbonate, polystyrene, polymethyl methacrylate, acrylonitrile-butadienestyrene copolymer, acrylonitrile-styrene copolymer, polyolefin, polyoxymethylene, polyesters, especially polyethylene terephthalate, polybutylene terephthalate, polysulphone, especially of type PSU, PESU, PPSU, polyphenylene ethers, polyphenylene sulphide, polyphenylene oxide, liquid-crystalline polymers, polyether ketone, polyether ether ketone, polyimide, polyamideimide, polyesterimide, polyetheramide, polyesteramide, polyetheresteramide, polyurethane, especially of type TPU, PUR, polysiloxane, polyacrylate, polymethacrylate, and also mixtures or copolymers based on such systems.

4. Moulding composition according to any of the preceding claims, **characterized in that** the fraction of component (A2_1) is in the range of 5-40 wt%, or in the range of 5-30 wt% or in the range of 5-20 wt%, based in each case on the sum of components (A1), (A2_1) and (A2_2).

5. Moulding composition according to any of the preceding claims, **characterized in that** component (A2_2) is selected from the group consisting of the following: olefin polymers, low-density, medium-density and high-density polyethylenes, polypropylene, polybutadiene, poly-4-methylpentene, ethylene-propylene block copolymers or random copolymers, ethylene-methylhexadiene copolymers, propylene-methylhexadiene copolymers, ethylene-propylene-butene copolymers, ethylene-propylene-hexene copolymers, ethylene-propylene-methylhexadiene copolymers, poly(ethylene-vinyl acetate) (EVA), poly(ethylene-ethyl acrylate) (EEA), ethylene-octene copolymer, ethylene-butene copolymer, ethylene-hexene copolymer, ethylene-propylene-diene terpolymers, and also combinations of the stated polymers, preferably functionalized with acid anhydride groups,
and/or **in that** the fraction of component (A2_2) is in the range of 5-40 wt%, preferably in the range of 5-30 wt% or in the range of 5-20 wt%, based in each case on the sum of components (A1), (A2_1) and (A2_2).

6. Moulding composition according to any of the preceding claims, **characterized in that** component (A1) consists of aliphatic polyamide or of a polyamide mixture which comprises at least 60 wt% of aliphatic polyamide, or 60 to 93 wt% of aliphatic polyamide, based in each case on the total amount of component (A1).

7. Moulding composition according to any of the preceding claims, **characterized in that** the fraction of component (A) is in the range of 25-84 wt%, or in the range of 30-80 wt%, with preferably component (A) being formed exclusively by component (A1) in the form of a polyamide or of a mixture of polyamides.

8. Moulding composition according to any of the preceding claims, **characterized in that** the fraction of component (B) is in the range of 15-60 wt%, or in the range of 18-55 wt%,
and/or **in that** the glass fibres of component (B) are present in the form of short fibres, preferably in the form of chopped glass having a length in the range of 0.2-20 mm, or in the form of continuous fibres.

9. Moulding composition according to any of the preceding claims, **characterized in that** component (B) is formed by glass fibres, preferably in the form of E-glass fibres according to ASTM D578-00 with a non-circular cross-section, the dimension ratio of the main cross-sectional axis to the secondary cross-sectional axis perpendicular thereto is more than 2.5, preferably in the range from 2.5 to 6, more particularly in the range from 3 to 5,
preferably composed of 52-62% silicon dioxide, 12-16% aluminium oxide, 16-25% calcium oxide, 0-10% borax, 0-5% magnesium oxide, 0-2% alkali metal oxides, 0-1.5% titanium dioxide and 0-0.3% iron oxide, or
preferably the glass fibres of component (B) are in the form of high-strength glass fibres based on the ternary system silicon dioxide-aluminium oxide-magnesium oxide or on the quaternary system silicon dioxide-aluminium oxide-magnesium oxide-calcium oxide, in which case they have the following composition: 58-70 wt%, preferably 60-67 wt%, silicon dioxide (SiO₂), 15-30 wt%, preferably 20-28 wt%, aluminium oxide (Al₂O₃), 5-15 wt%, preferably 7-12 wt%, magnesium oxide (MgO), 0-10 wt%, preferably 0-9 wt%, calcium oxide (CaO) and 0-2 wt%, preferably 0-1.5 wt%, further oxides, such as, in particular, zirconium dioxide (ZrO₂), boron oxide (B₂O₃), titanium dioxide (TiO₂) or lithium oxide (Li₂O) or a combination of these oxides.

10. Moulding composition according to any of the preceding claims, **characterized in that** the fraction of component (C) is in the range of 0.5-8 wt%, preferably in the range of 1-6 wt%.

11. Moulding composition according to any of the preceding claims, **characterized in that** component (C) is an laser direct structuring additive having an average particle size (d₅₀) in the range of 50-20 000 nanometres, or 200 to 15 000 nanometres or 300 to 5000 nanometres.

12. Moulding composition according to any of the preceding claims, **characterized in that** component (C) is an laser direct structuring additive selected from the following group: metal-doped or metal oxide-doped tin oxides, preferably antimony-doped or antimony oxide-doped tin oxides; metal oxide mixtures with tin oxide which are formed as layers on platelet-shaped substrates, more particularly phyllosilicates, such as preferably synthetic or natural mica, talc, kaolin, glass flakes or SiO₂ platelets; mica coated with antimony-doped tin oxide; mixture of tin oxide and antimony oxide and/or indium oxide and/or zinc fluoride; copper oxide; copper hydroxide; copper hydroxide phosphate; copper phosphate; alkaline copper phosphates; copper tin phosphate, alkaline copper tin phosphate; tin phosphate; alkaline tin phosphate; or a mixture of such laser direct structuring additives.

13. Moulding composition according to any of the preceding claims, **characterized in that** the fraction of component (D) is in the range of 0.5-20 wt%, or in the range of 5-10, or in the range of 1-8 wt%, or in the range of 2-6 wt% or 2-5 wt%,
and/or **in that** component (D) is selected from the following group: barium sulphate; titanium dioxide, in the rutile or the anatase modification; zinc oxide; lithopones; titanium zinc mixed oxides; zinc sulphide; or a mixture thereof, especially zinc sulphide, in which case preferably component (D) is formed exclusively by zinc sulphide.

14. Moulding composition according to any of the preceding claims, **characterized in that** the fraction of component (E) is in the range of 0-18 wt%, or in the range of 0-15 wt%, or in the range of 2-15 wt% or 3-10 wt%.

15. Component, more particularly component with electrical conductor tracks, based on a moulding composition according to any of the preceding claims, preferably as casing or casing part for portable electronic devices, such as especially PDAs, mobile telephones, telecommunications devices, casings or casing parts for personal computers, notebooks, medical devices, such as, in particular, hearing devices, sensor technology, or Radio Frequency IDentification (RFID) transponders or parts for the automotive sector, such as, in particular, airbag module and multi-function steering wheel.

## Revendications

1. Masse de moulage thermoplastique, constituée par
(A) 20-88% en poids d'un mélange constitué par
(A1) 60-100% en poids d'un matériau thermoplastique ou d'un mélange de matériaux thermoplastiques, constitué par
(A1_1) 40-100% en poids de polyamide aliphatique
(A1_2) 0-60% en poids de polyamide amorphe, partiellement aromatique
la somme des composants (A1_1) et (A1_2) se complétant à 100% en poids de composant (A1) ;
(A2) 0-40% en poids d'un mélange constitué par
(A2_1) 0-40% en poids d'un matériau thermoplastique différent de (A1) ou d'un mélange de matériaux thermoplastiques différent de (A1) ;
(A2_2) 0-40% en poids d'un agent de modification de la résilience, différents de (A1) et de (A2_1) ;
la somme des composants (A1), (A1_2) et (A2_2) se complétant à 100% en poids de composant (A) ;
(B) 10-70% en poids d'adjuvants sous forme de fibres ;
(C) 0,1-10% en poids d'un additif de structuration directe par laser (Laser Direct Structuring - LDS) ou d'un mélange d'additifs de structuration directe par laser, au moins un additif de structuration directe par laser étant choisi dans le groupe suivant : un oxyde métallique à base de cuivre, d'indium, de néodyme, de molybdène, de bismuth ou d'étain ou de leurs mélanges, sous réserve que les spinelles sont exclues ; un phosphate métallique ; un hydroxyphosphate métallique ;
(D) 0,1-20% en poids de pigment blanc ;
(E) 0-20% en poids de charge particulaire, différente de C et/ou de D ;
(F) 0-2% en poids d'autres additifs, différents ;
la somme de (A) à (F) valant 100% en poids.

2. Masse de moulage selon la revendication 1, **caractérisée en ce que** les polyamides aliphatiques du composant (A1_1) sont choisis dans le groupe constitué par : le polyamide 11, le polyamide 12, le polyamide 1212, le polyamide 1010, le polyamide 1012, le polyamide 1112, le polyamide 610, le polyamide 612, le polyamide 69, le polyamide 810 ou leurs mélanges, assemblages ou alliages, le PA 1010 étant particulièrement préféré.

3. Masse de moulage selon l'une quelconque des revendications précédentes, **caractérisée en ce que** le composant (A2_1) est choisi dans le groupe constitué par : le polyamide, le polycarbonate, le polystyrène, le poly(méthacrylate de méthyle), un copolymère d'acrylonitrile-butadiène-styrène, un copolymère d'acrylonitrile-styrène, une polyoléfine, le polyoxyméthylène, un polyester, en particulier le poly(téréphtalate d'éthylène), le poly(téréphtalate de butylène), une polysulfone, en particulier du type PSU, PESU, PPSU, le polyphénylénéther, le poly(sulfure de phénylène), le poly(oxyde de phénylène), les polymères à cristaux liquides, la polyéthercétone, la polyétheréthercétone, le polyimide, le polyamide-imide, le polyesterimide, le polyétheramide, le polyesteramide, le polyétheresteramide, un polyuréthane, en particulier du type TPU, PUR, le polysiloxane, le polyacrylate, le polyméthacrylate ainsi que les mélanges ou les copolymères à base de ces systèmes.

4. Masse de moulage selon l'une quelconque des revendications précédentes, **caractérisée en ce que** la proportion de composant (A2_1) se situe dans la plage de 5-40% en poids ou dans la plage de 5-30% en poids ou dans la plage de 5-20% en poids, à chaque fois par rapport à la somme des composants (A1), (A2_1) et (A2_2).

5. Masse de moulage selon l'une quelconque des revendications précédentes, **caractérisée en ce que** le composant (A2_2) est choisi dans le groupe constitué par : les polymères oléfiniques, le polyéthylène de basse, moyenne et haute densité, le polypropylène, le polybutadiène, le poly-4-méthylpentène, les copolymères séquencés ou aléatoires d'éthylène-propylène, les copolymères d'éthylène-méthylhexadiène, les copolymères de propylène-méthylhexadiène, les copolymères d'éthylène-propylène-butène, les copolymères d'éthylène-propylène-hexène, les copolymères d'éthylène-propylène-méthylhexadiène, le poly(éthylène-acétate de vinyle) (EVA), le poly(éthylène-acrylate d'éthyle) (EEA), le copolymère d'éthylène-octène, le copolymère d'éthylène-butène, le copolymère d'éthylène-hexène, les terpolymères d'éthylène-propylène-diène ainsi que les combinaisons des polymères mentionnés, de préférence fonctionnalisés par des groupes anhydride d'acide et/ou **en ce que** la proportion du composant (A2_2) se situe dans la plage de 5-40% en poids ou dans la plage de 5-30% en poids ou dans la plage de 5-20% en poids, à chaque fois par rapport à la somme des composants (A1), (A2_1) et (A2_2).

6. Masse de moulage selon l'une quelconque des revendications précédentes, **caractérisée en ce que** le composant (A1) est constitué par du polyamide aliphatique ou par un mélange de polyamides, qui contient au moins 60% en poids de polyamide aliphatique ou 60 à 93% en poids de polyamide aliphatique, à chaque fois par rapport à la quantité totale de composant (A1).

7. Masse de moulage selon l'une quelconque des revendications précédentes, **caractérisée en ce que** la proportion de composant (A) se situe dans la plage de 25-84% en poids ou dans la plage de 30-80% en poids, le composant (A) étant de préférence exclusivement formé par le composant (A1) sous forme d'un polyamide ou d'un mélange de polyamides.

8. Masse de moulage selon l'une quelconque des revendications précédentes, **caractérisée en ce que** la proportion de composant (B) se situe dans la plage de 15-60% en poids ou dans la plage de 18-55% en poids et/ou **en ce que** les fibres de verre du composant (B) se trouvent sous forme de fibres courtes, de préférence sous forme de verre découpé présentant une longueur dans la plage de 0,2-20 mm, ou sous forme de fibres continues.

9. Masse de moulage selon l'une quelconque des revendications précédentes, **caractérisée en ce que** le composant (B) est formé par des fibres de verre, de préférence sous forme de fibres de verre E selon la norme ASTM D578-00 présentant une section transversale non circulaire, le rapport des dimensions de l'axe transversal principal à l'axe transversal secondaire perpendiculaire à celui-ci étant supérieur à 2,5, de préférence situé dans la plage de 2,5 à 6, en particulier dans la plage de 3 à 5, de préférence constituées par 52-62% de dioxyde de silicium, 12-16% d'oxyde d'aluminium, 16-25% d'oxyde de calcium, 0-10% de borax, 0-5% d'oxyde de magnésium, 0-2% d'oxydes de métal alcalin, 0-1,5% de dioxyde de titane et 0-0,3% d'oxyde de fer, ou, de préférence, les fibres de verre du composant (B) en tant que fibres de verre hautement résistantes sont à base du système ternaire dioxyde de silicium-oxyde d'aluminium-oxyde de magnésium ou du système quaternaire dioxyde de silicium-oxyde d'aluminium-oxyde de magnésium-oxyde de calcium, présentant la composition suivante : 58-70% en poids, de préférence 60-67% en poids de dioxyde de silicium (SiO₂), 15-30% en poids, de préférence 20-28% en poids d'oxyde d'aluminium (Al₂O₃), 5-15% en poids, de préférence 7-12% en poids d'oxyde de magnésium (MgO), 0-10% en poids, de préférence 0-9% en poids d'oxyde de calcium (CaO) et 0-2% en poids, de préférence 0-1,5% en poids d'autres oxydes, tels qu'en particulier le dioxyde de zirconium (ZrO₂), l'oxyde de bore (B₂O₃), le dioxyde de titane (TiO₂) ou l'oxyde de lithium (Li₂O) ou une combinaison de ces oxydes.

10. Masse de moulage selon l'une quelconque des revendications précédentes, **caractérisée en ce que** la proportion de composant (C) se situe dans la plage de 0,5-8% en poids ou dans la plage de 1-6% en poids.

11. Masse de moulage selon l'une quelconque des revendications précédentes, **caractérisée en ce que** le composant (C) est un additif de structuration directe par laser présentant une grosseur moyenne de particule (d₅₀) dans la plage de 50-20.000 nanomètres ou de 200 à 15.000 nanomètres ou de 300 à 5000 nanomètres.

12. Masse de moulage selon l'une quelconque des revendications précédentes, **caractérisée en ce qu'**il s'agit, pour le composant (C), d'un additif de structuration directe par laser choisi dans le groupe suivant : oxydes d'étain dopés par un métal ou un oxyde métallique, de préférence oxydes d'étain dopés par de l'antimoine ou de l'oxyde d'antimoine ; des mélanges d'oxyde métallique avec de l'oxyde d'étain, qui sont formés en tant que couches sur des substrats en forme de plaquette, en particulier des silicates à couches, comme par exemple le mica synthétique ou naturel, le talc, le kaolin, les plaquettes de verre ou les plaquettes de SiO₂ ; le mica revêtu d'oxyde d'étain dopé par de l'antimoine ; un mélange d'oxyde d'étain et d'oxyde d'antimoine et/ou d'oxyde d'indium et/ou de fluorure de zinc ; l'oxyde de cuivre ; l'hydroxyde de cuivre ; l'hydroxyphosphate de cuivre ; le phosphate de cuivre; le phosphate de cuivre basique ; le phosphate de cuivre et d'étain ; le phosphate de cuivre et d'étain basique ; le phosphate d'étain ; le phosphate d'étain basique ; ou un mélange de ces additifs de structuration directe au laser.

13. Masse de moulage selon l'une quelconque des revendications précédentes, **caractérisée en ce que** la proportion de composant (D) se situe dans la plage de 0,5-20% en poids ou dans la plage de 5-10% en poids ou dans la plage de 1-8% en poids ou dans la plage de 2-6% en poids ou de 2-5% en poids et/ou **en ce que** le composant (D) est choisi dans le groupe suivant : le sulfate de baryum ; le dioxyde de titane, sous forme de la modification rutile ou anatase ; l'oxyde de zinc ; les lithopones ; les oxydes mixtes de titane-zinc ; le sulfure de zinc ; ou un mélange de ceux-ci, en particulier le sulfure de zinc, le composant (D) étant de préférence formé exclusivement par du sulfure de zinc.

14. Masse de moulage selon l'une quelconque des revendications précédentes, **caractérisée en ce que** la proportion de composant (E) se situe dans la plage de 0-18% en poids ou dans la plage de 0-15% en poids ou dans la plage de 2-15% en poids ou de 3-10% en poids.

15. Pièce, en particulier pièce présentant des pistes conductrices électriques, à base d'une masse de moulage selon l'une quelconque des revendications précédentes, de préférence sous forme de boîtier ou de partie de boîtier pour des appareils électroniques portables, tels qu'en particulier des organiseurs (PDA), des téléphones mobiles, des appareils de télécommunications ; de boîtiers ou de parties de boîtier pour des ordinateurs personnels, des ordinateurs portables ; des appareils médicaux, tels qu'en particulier des appareils auditifs ; la technique de capteurs ou des transpondeurs RFID (identification par radiofréquences) ; ou des pièces pour le domaine automobile, telles qu'en particulier un module d'airbag et un volant multifonction.
